# EUROPEAN PATENT SPECIFICATION

(11) **EP 1 575 219 B1**
(45) Date of publication and mention of the grant of the patent: **16.05.2007**
(21) Application number: 05005259.6
(22) Date of filing: 10.03.2005
(51) Int. Cl.: H04L 12/413

(54) **Apparatus, method, and program for preventing collisions in data-transmission and computer-readable record medium for storing the program**
Gerät, Verfahren und Programm zur Vermeidung von Kollisionen bei der Datenübertragung sowie computer-lesbares Speichermedium für das Programm
Appareil, procédé et logiciel pour éviter des collisions dans la transmission de données et médium de stockage lisible par ordinateur pour ce logiciel

(30) Priority: 12.03.2004 JP 2004070416
(43) Date of publication of application: 14.09.2005
(73) Proprietor: MATSUSHITA ELECTRIC INDUSTRIAL CO., LTD., Kadoma-shi, Osaka 571-8501 (JP)
(72) Inventor: Murakami, Takashi, Kyoto-shi Kyoto (JP)
(74) Representative: TBK-Patent

(56) References cited:
- US-A- 5 625 626
- US-A- 5 963 560
- US-A1- 2003 103 521

## Description

### Background of the Invention

### Field of the Invention;

The present invention relates to a communication apparatus, a communication method, and a computer-readable record medium where a communication program is recorded, which are capable of establishing the communication of 1:1 by executing sequence management when the communication apparatus which has a communication function and is connected to a wired or radio communication line communicates with another communication apparatus which is connected to a communication line in the same way.

### Description of the related art:

Conventionally, a communication management apparatus is known which adjusts the interval at which data is transmitted onto a physical circuit according to the load level, so that a communication processing can be smoothly continued (e.g., refer to Japanese Unexamined Patent Publication No. 06-62081 specification). In this communication management apparatus, abrupt control is not executed, such as a sudden halt of all transmissions and their simultaneous resumption. In other words, smooth control is executed according to the load. This helps lighten a load on the system and a circuit buffer.

Herein, even if a communication is slow and an unreliable communication medium is used, a communication needs to be certainly executed in real time, and in addition, the system has to be reliable while communicating. However, the above described communication management apparatus is connected to a communication medium to build a network. In some cases, such a communication medium is not always reliable.

### Brief Summary of Invention

In order to resolve the above described disadvantage, it is an object of the present invention to provide a communication apparatus, a communication method, and a computer-readable record medium where a communication program is recorded, which are capable of making communication more reliable.

The communication apparatus according to the present invention, which transmits and receives data to and from another communication apparatus, via a communication medium, comprising: a transmission-request data creating means for creating transmission request data which includes data type information that indicates a transmission destination of transmission data to be transmitted and whether or not a response should be made to the transmission data; a communication-medium type-information storing means for storing communication-medium type information that indicates the type of the communication medium; a communication mediation processing means for mediating the timing in transmitting the transmission data, based on the data type information which is included in the transmission request data that is created by the transmission-request data creating means and the communication-medium type information which is stored in the type-information storing means; and a data transmitting means for transmitting the transmission data according to the timing which is mediated by the communication mediation processing means.

According to this configuration, the transmission request data is created which includes data type information that indicates a transmission destination of transmission data to be transmitted and whether or not a response should be made to the transmission data. Then, the timing in transmitting the transmission data is mediated, based on the data type information which is included in the transmission request data and the communication-medium type information that indicates the type of the communication medium which is stored in the type-information storing means. Sequentially, the transmission data is transmitted according to the mediated timing.

Hence, the timing in transmitting the transmission data is mediated, based on the transmission destination of the transmission data, whether or not a response should be made to the transmission data and the type of the communication medium. Therefore, several communication apparatuses which are connected to a network can communicate with each other, virtually in the form of 1:1. Thereby, while a communication is executed, its data can be prevented from colliding with another piece of data on the communication medium. This keeps the transmission data from vanishing, thus making the communication more reliable.

Furthermore, in the above described communication apparatus, it is preferable that the transmission-request data include data type information which indicates that the transmission data to be transmitted is: individual response-request data which designates a specific transmission destination individually and requests a response from the transmission destination of the transmission data; individual no-response-request data which designates a specific transmission destination individually and does not request a response from the transmission destination of the transmission data; broadcast response-request data which transmits the transmission data broadcast without specifying a transmission destination and requests a response from the transmission destination of the transmission data; or broadcast no-response-request data which transmits the transmission data broadcast without specifying a transmission destination and does not request a response from the transmission destination of the transmission data; and the communication mediation processing means mediate the timing in transmitting the transmission data, based on the data type information which is included in the transmission request data that is created by the transmission-request data creating means and the communication-medium type information which is stored in the communication-medium type-information storing means.

According to this configuration, in the transmission-request data, data type information is included which indicates that the transmission data to be transmitted is: individual response-request data which designates a specific transmission destination individually and requests a response from the transmission destination of the transmission data; individual no-response-request data which designates a specific transmission destination individually and does not request a response from the transmission destination of the transmission data; broadcast response-request data which transmits the transmission data broadcast without specifying a transmission destination and requests a response from the transmission destination of the transmission data; or broadcast no-response-request data which transmits the transmission data broadcast without specifying a transmission destination and does not request a response from the transmission destination of the transmission data. Then, the timing in transmitting the transmission data is mediated, based on the data type information which is included in the transmission request data and the communication-medium type information which is stored in the communication-medium type-information storing means.

Hence, a confirmation is obtained whether the data type information is the individual response-request data, the individual no-response-request data, the broadcast response-request data or the broadcast no-response-request data. This makes it possible to easily specify the transmission destination of the data and whether or not the response should be made.

Moreover, in the above described communication apparatus, preferably, a communication data table should be further provided for managing the transmission-request data; in the communication data table, each piece of transmission-request data should be stored so as to correspond to a transmission state; and the communication mediation processing means should mediate the timing in transmitting the transmission data, based on the data type information which is included in the transmission request data that is created by the transmission-request data creating means, the communication-medium type information which is stored in the communication-medium type-information storing means, and the transmission state which is stored in the communication data table.

According to this configuration, in the communication data table for managing the transmission-request data, each piece of transmission-request data should be stored so as to correspond to a transmission state. Then, the timing in transmitting the transmission data is mediated, based on the data type information which is included in the transmission request data, the communication-medium type information which is stored in the communication-medium type-information storing means, and the transmission state which is stored in the communication data table.

Hence, the timing in transmitting the transmission data is mediated, taking into account, not only the data type information and the communication-medium type information, but also the transmission state of the transmission request data. This helps make the communication more reliable.

In addition, in the above described communication apparatus, it is preferable that the communication mediation processing means: if the transmission-request data is inputted, store, in the communication data table, the data type information which is included in the transmission-request data, and set the transmission state to a transmission waiting state; if the data type information is the individual response-request data, confirm the transmission states of the other pieces of transmission-request data which are stored in the communication data table; and if the transmission states of all the other pieces of transmission-request data are not in a response waiting state, output the transmission-request data to the data transmitting means, and change, into the response waiting state, the transmission state of the transmission-request data which is stored in the communication data table.

According to this configuration, if the transmission-request data is inputted, the data type information which is included in the transmission-request data is stored in the communication data table, and the transmission state is set to a transmission waiting state. Then, if the data type information is the individual response-request data, the transmission states are confirmed of the other pieces of transmission-request data which are stored in the communication data table. Herein, if the transmission states of all the other pieces of transmission-request data are not in a response waiting state, the transmission-request data is outputted to the data transmitting means, and the transmission state of the transmission-request data which is stored in the communication data table is changed into the response waiting state.

Hence, if the data type information is the individual response-request data, the transmission-request data is transmitted when the transmission states of all the other pieces of transmission-request data are not in a response waiting state. Therefore, the confirmation can be obtained there is no response data to another piece of transmission data on the communication medium. This prevents the data from colliding with another piece of data.

Furthermore, in the above described communication apparatus, preferably, the data transmitting means should have the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses; and the communication mediation processing means: if the transmission-request data is inputted, should store, in the communication data table, the data type information which is included in the transmission-request data, and should set the transmission state to a transmission waiting state; if the data type information is the individual response-request data, should confirm the transmission states of the other pieces of transmission-request data which are stored in the communication data table; and if the transmission states of all the other pieces of transmission-request data are not in a response waiting state, or if the transmission states of some of the other pieces of transmission-request data are in the response waiting state and all the transmission destinations of some of the other pieces of transmission-request data which are in the response waiting state are different from the transmission destination of the transmission-request data, should output the transmission-request data to the data transmitting means, and should change, into the response waiting state, the transmission state of the transmission-request data which is stored in the communication data table.

According to this configuration, the data transmitting means has the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table, and the transmission state is set to a transmission waiting state. Then, if the stored data type information is the individual response-request data, when the transmission states of all the other pieces of transmission-request data are not in a response waiting state, or when the transmission states of some of the other pieces of transmission-request data are in the response waiting state and all the transmission destinations of some of the other pieces of transmission-request data which are in the response waiting state are different from the transmission destination of the transmission-request data, the transmission-request data is outputted to the data transmitting means, and the transmission state of the transmission-request data which is stored in the communication data table is changed into the response waiting state.

Hence, the data transmitting means has the function of preventing data from colliding. If the data type information is the individual response-request data, the data is transmitted when the transmission destination of the transmission data is different from the transmission origin of the response data. This prevents the data from colliding.

Moreover, in the above described communication apparatus, it is preferable that the communication mediation processing means: if the transmission-request data is inputted, store, in the communication data table, the data type information which is included in the transmission-request data, and set the transmission state to a transmission waiting state; if the data type information is the individual no-response-request data, confirm the transmission states of the other pieces of transmission-request data which are stored in the communication data table; and if the transmission states of all the other pieces of transmission-request data are not in a response waiting state, output the transmission-request data to the data transmitting means, and change, into a transmission completion state, the transmission state of the transmission-request data which is stored in the communication data table.

According to this configuration, if the transmission-request data is inputted, the data type information which is included in the transmission-request data is stored in the communication data table, and the transmission state is set to a transmission waiting state. Then, if the stored data type information is the individual no-response-request data, when the transmission states of all the other pieces of transmission-request data are not in a response waiting state, the transmission-request data is outputted to the data transmitting means, and the transmission state of the transmission-request data which is stored in the communication data table is changed into a transmission completion state.

Hence, if the data type information is the individual no-response-request data, the transmission-request data is transmitted when the transmission states of all the other pieces of transmission-request data are not in a response waiting state. Therefore, the confirmation can be obtained there is no response data to another piece of transmission data on the communication medium. This prevents the data from colliding.

In addition, in the above described communication apparatus, preferably, the data transmitting means should have the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses; and the communication mediation processing means: if the transmission-request data is inputted, should store, in the communication data table, the data type information which is included in the transmission-request data, and should set the transmission state to a transmission waiting state; if the data type information is the individual no-response-request data, should confirm the transmission states of the other pieces of transmission-request data which are stored in the communication data table; and if the transmission states of all the other pieces of transmission-request data are not in a response waiting state, or if the transmission states of some of the other pieces of transmission-request data are in the response waiting state and all the transmission destinations of some of the other pieces of transmission-request data which are in the response waiting state are different from the transmission destination of the transmission-request data, should output the transmission-request data to the data transmitting means, and should change, into a transmission completion state, the transmission state of the transmission-request data which is stored in the communication data table.

According to this configuration, the data transmitting means has the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table, and the transmission state is set to a transmission waiting state. Then, if the stored data type information is the individual no-response-request data, when the transmission states of all the other pieces of transmission-request data are not in a response waiting state, or when the transmission states of some of the other pieces of transmission-request data are in the response waiting state and all the transmission destinations of some of the other pieces of transmission-request data which are in the response waiting state are different from the transmission destination of the transmission-request data, the transmission-request data is outputted to the data transmitting means, and the transmission state of the transmission-request data which is stored in the communication data table is changed into the transmission completion state.

Hence, the data transmitting means has the function of preventing data from colliding. If the data type information is the individual no-response-request data, the data is transmitted when the transmission destination of the transmission data is different from the transmission origin of the response data. This prevents the data from colliding.

Furthermore, in the above described communication apparatus, it is preferable that the communication mediation processing means: if the transmission-request data is inputted, store, in the communication data table, the data type information which is included in the transmission-request data, and set the transmission state to a transmission waiting state; if the data type information is the broadcast response-request data, confirm the transmission states of the other pieces of transmission-request data which are stored in the communication data table; and if the transmission states of all the other pieces of transmission-request data are not in a response waiting state, output the transmission-request data to the data transmitting means, and change, into the response waiting state, the transmission state of the transmission-request data which is stored in the communication data table.

According to this configuration, if the transmission-request data is inputted, the data type information which is included in the transmission-request data is stored in the communication data table, and the transmission state is set to a transmission waiting state. Then, if the stored data type information is the broadcast response-request data, when the transmission states of all the other pieces of transmission-request data are not in a response waiting state, the transmission-request data is outputted to the data transmitting means, and the transmission state of the transmission-request data which is stored in the communication data table is changed into the response waiting state.

Hence, if the data type information is the broadcast response-request data, the transmission-request data is transmitted when the transmission states of all the other pieces of transmission-request data are not in a response waiting state. Therefore, the confirmation can be obtained there is no response data to another piece of transmission data on the communication medium. This prevents the data from colliding.

Moreover, in the above described communication apparatus, preferably, the data transmitting means should have the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses; and the communication mediation processing means: if the transmission-request data is inputted, should store, in the communication data table, the data type information which is included in the transmission-request data, and should set the transmission state to a transmission waiting state; if the data type information is the broadcast response-request data, should confirm the transmission states of the other pieces of transmission-request data which are stored in the communication data table; and if the transmission states of all the other pieces of transmission-request data are not in a response waiting state, or if the transmission states of some of the other pieces of transmission-request data are in the response waiting state and all the types of some of the other pieces of transmission-request data which are in the response waiting state are broadcast, should output the transmission-request data to the data transmitting means, and should change, into the response waiting state, the transmission state of the transmission-request data which is stored in the communication data table.

According to this configuration, the data transmitting means has the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table, and the transmission state is set to a transmission waiting state. Then, if the stored data type information is the broadcast response-request data, the transmission states of the other pieces of transmission-request data are confirmed which are stored in the communication data table. Herein, if the transmission states of all the other pieces of transmission-request data are not in a response waiting state, or if the transmission states of some of the other pieces of transmission-request data are in the response waiting state and all the types of some of the other pieces of transmission-request data which are in the response waiting state are broadcast, the transmission-request data is outputted to the data transmitting means, and the transmission state of the transmission-request data which is stored in the communication data table is changed into the response waiting state.

In the case of broadcast transmission, the transmission data is transmitted to other unspecified communication apparatuses. Therefore, response data is not necessarily sent, and thus, response data may be already replied from all of other communication apparatuses. As a result, in the case of a broadcast transmission, even if the transmission data is transmitted without waiting for response data to come, the transmission data is unlikely to collide with the response data. Hence, the data transmitting means has the function of preventing data from colliding. If the data type information is the broadcast response-request data, the data is transmitted when all the types of the pieces of transmission-request data in the response waiting state are broadcast. This prevents the data from colliding.

In addition, in the above described communication apparatus, it is preferable that the communication mediation processing means: if the transmission-request data is inputted, store, in the communication data table, the data type information which is included in the transmission-request data, and set the transmission state to a transmission waiting state; if the data type information is the broadcast no-response-request data, confirm the transmission states of the other pieces of transmission-request data which are stored in the communication data table; and if the transmission states of all the other pieces of transmission-request data are not in a response waiting state, output the transmission-request data to the data transmitting means, and change, into a transmission completion state, the transmission state of the transmission-request data which is stored in the communication data table.

According to this configuration, if the transmission-request data is inputted, the data type information which is included in the transmission-request data is stored in the communication data table, and the transmission state is set to a transmission waiting state. Then, if the stored data type information is the broadcast no-response-request data, when the transmission states of all the other pieces of transmission-request data are not in a response waiting state, the transmission-request data is outputted to the data transmitting means, and the transmission state of the transmission-request data which is stored in the communication data table is changed into the transmission completion state.

Hence, if the data type information is the broadcast no-response-request data, the transmission-request data is transmitted when the transmission states of all the other pieces of transmission-request data are not in a response waiting state. Therefore, the confirmation can be obtained there is no response data to another piece of transmission data on the communication medium. This prevents the data from colliding.

Furthermore, in the above described communication apparatus, preferably, the data transmitting means should have the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses; and the communication mediation processing means: if the transmission-request data is inputted, should store, in the communication data table, the data type information which is included in the transmission-request data, and should set the transmission state to a transmission waiting state; if the data type information is the broadcast no-response-request data, should confirm the transmission states of the other pieces of transmission-request data which are stored in the communication data table; and if the transmission states of all the other pieces of transmission-request data are not in a response waiting state, or if the transmission states of some of the other pieces of transmission-request data are in the response waiting state and all the types of some of the other pieces of transmission-request data which are in the response waiting state are broadcast, should output the transmission-request data to the data transmitting means, and should change, into a transmission completion state, the transmission state of the transmission-request data which is stored in the communication data table.

According to this configuration, the data transmitting means has the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table, and the transmission state is set to a transmission waiting state. Then, if the stored data type information is the broadcast no-response-request data, when the transmission states of all the other pieces of transmission-request data are not in a response waiting state, or if the transmission states of some of the other pieces of transmission-request data are in the response waiting state and all the types of some of the other pieces of transmission-request data which are in the response waiting state are broadcast, the transmission-request data is outputted to the data transmitting means, and the transmission state of the transmission-request data which is stored in the communication data table is changed into the transmission completion state.

In the case of a broadcast transmission, the transmission data is transmitted to other unspecified communication apparatuses. Therefore, response data is not necessarily sent, and thus, response data may be already replied from all of other communication apparatuses. As a result, in the case of a broadcast transmission, even if the transmission data is transmitted without waiting for response data to come, the transmission data is unlikely to collide with the response data. Hence, the data transmitting means has the function of preventing data from colliding. If the data type information is the broadcast no-response-request data, the data is transmitted when all the types of the pieces of transmission-request data in the response waiting state are broadcast. This prevents the data from colliding.

Moreover, in the above described communication apparatus, it is preferable that the communication mediation processing means: if the transmission-request data is inputted, store, in the communication data table, the data type information which is included in the transmission-request data, and set the transmission state to a transmission waiting state; if the data type information is the individual response-request data or the broadcast response-request data, after the transmission-request data is transmitted by the data transmitting means, change, into a response waiting state, the transmission state which corresponds to the transmission-request data; and if no response is made even though a predetermined period of time elapses after the transmission state is changed into the response waiting state, change the transmission state into a time-out state.

According to this configuration, if the transmission-request data is inputted, the data type information which is included in the transmission-request data is stored in the communication data table, and the transmission state is set to a transmission waiting state. Then, if the stored data type information is the individual response-request data or the broadcast response-request data, after the transmission-request data is transmitted, the transmission state which corresponds to the transmitted transmission-request data is changed into a response waiting state. Sequentially, if no response is made even though a predetermined period of time elapses after the transmission state is changed into the response waiting state, the transmission state into a time-out state is changed.

Hence, if no response has been made since the transmission state was shifted into the response waiting state, even though a predetermined period of time has elapsed, then it is shifted into a time-out state without waiting for a response. This makes it possible to continue executing the processing without stopping it, even if there is no response.

In addition, in the above described communication apparatus, preferably, the communication mediation processing means should set the predetermined period from the time when the transmission state is changed into the response waiting state to the time when the transmission state is shifted into the time-out state, according to the communication-medium type information which is stored in the communication-medium type-information storing means.

According to this configuration, the predetermined period from the time when the transmission state is changed into the response waiting state to the time when the transmission state is shifted into the time-out state, is set according to the communication-medium type information which is stored in the communication-medium type-information storing means. Hence, the predetermined period during which the response waiting state is shifted into the time-out state, can be set according to the speed at which a communication medium transmits data. Specifically, if a communication medium transmits data fast, the predetermined period is set short. Thereby, the speed at which a communication processing is executed becomes higher. On the other hand, if a communication medium transmits data slowly, the predetermined period is set long. This makes communication more reliable.

Furthermore, in the above described communication apparatus, it is preferable that the communication mediation processing means set the predetermined period from the time when the transmission state is changed into the response waiting state to the time when the transmission state is shifted into the time-out state, according to the data length of the transmission-request data.

According to this configuration, the predetermined period from the time when the transmission state is changed into the response waiting state to the time when the transmission state is shifted into the time-out state, is set according to the data length of the transmission-request data. Hence, the predetermined period during which the response waiting state is shifted into the time-out state, can be set according to the time which is taken for a communication medium to transmit data. Specifically, if the data length of transmission-request data is short, the time which is taken to transmit it becomes short. Thus, the predetermined period is set short, so that the speed of a communication processing becomes higher. On the other hand, if the data length of transmission-request data is long, the time which is taken to transmit it becomes long. Thus, the predetermined period is set long, so that communication becomes more reliable.

Moreover, in the above described communication apparatus, preferably, the communication mediation processing means should set the predetermined period from the time when the transmission state is changed into the response waiting state to the time when the transmission state is shifted into the time-out state, according to the data length of response data to the transmission data.

According to this configuration, the predetermined period from the time when the transmission state is changed into the response waiting state to the time when the transmission state is shifted into the time-out state, is set according to the data length of response data to the transmission data. Hence, the predetermined period during which the response waiting state is shifted into the time-out state, can be set according to the time which is taken for a communication medium to transmit the response data. Specifically, if the data length of response data is short, the time which is taken to transmit it becomes short. Thus, the predetermined period is set short, so that the speed of a communication processing becomes higher. On the other hand, if the data length of response data is long, the time which is taken to transmit it becomes long. Thus, the predetermined period is set long, so that communication becomes more reliable.

In addition, in the above described communication apparatus, it is preferable that the transmission-request data include communication-medium specification information for specifying a communication medium to be used from among a plurality of the communication mediums which have a different standard from each other; the communication mediation processing means specify a communication medium which transmits the transmission data, based on the communication-medium specification information that is included in the transmission-request data; and the data transmitting means transmit the transmission data, using the communication medium which is specified by the communication mediation processing means.

According to this configuration, in the transmission-request data, there is included communication-medium specification information for specifying a communication medium to be used from among a plurality of the communication mediums which have a different standard from each other. Besides, a communication medium which transmits the transmission data is specified, based on the communication-medium specification information that is included in the transmission-request data. Then, the transmission data is transmitted using the specified communication medium. Hence, the communication medium which transmits the data is switched and used. Thereby, the transmission data can be transmitted, using a plurality of communication mediums which have a different standard from each other.

The communication method according to the present invention, in which data is transmitted to and received from another communication apparatus, via a communication medium, comprising: a transmission-request data creating step of creating transmission request data which includes data type information that indicates a transmission destination of transmission data to be transmitted and whether or not a response should be made to the transmission data; a communication-medium type-information storing step of storing communication-medium type information that indicates the type of the communication medium; a communication mediation processing step of mediating the timing in transmitting the transmission data, based on the data type information which is included in the transmission request data that is created in the transmission-request data creating step and the communication-medium type information which is stored in the type-information storing step; and a data transmission processing step of transmitting the transmission data according to the timing which is mediated in the communication mediation processing step.

According to this configuration, the transmission request data is created which includes data type information that indicates a transmission destination of transmission data to be transmitted and whether or not a response should be made to the transmission data. Then, the timing in transmitting the transmission data is mediated, based on the data type information which is included in the transmission request data and the communication-medium type information that indicates the type of the communication medium which is stored in the type-information storing means. Sequentially, the transmission data is transmitted according to the mediated timing.

Hence, the timing in transmitting the transmission data is mediated, based on the transmission destination of the transmission data, whether or not a response should be made to the transmission data and the type of the communication medium. Therefore, several communication apparatuses which are connected to a network can communicate with each other, virtually in the form of 1:1. Thereby, while a communication is executed, its data can be prevented from colliding with another piece of data on the communication medium. This keeps the transmission data from vanishing, thus making the communication more reliable.

The computer-readable record medium according to the present invention, in which a communication program is recorded for transmitting and receiving data to and from another communication apparatus, via a communication medium, wherein the computer-readable record medium in which the communication program is recorded allows a computer to function as: a transmission-request data creating means for creating transmission request data which includes data type information that indicates a transmission destination of transmission data to be transmitted and whether or not a response should be made to the transmission data; a communication-medium type-information storing means for storing communication-medium type information that indicates the type of the communication medium; a communication mediation processing means for mediating the timing in transmitting the transmission data, based on the data type information which is included in the transmission request data that is created by the transmission-request data creating means and the communication-medium type information which is stored in the communication-medium type-information storing means; and a data transmitting means for transmitting the transmission data according to the timing which is mediated by the communication mediation processing means.

According to this configuration, transmission request data is created which includes data type information that indicates a transmission destination of transmission data to be transmitted and whether or not a response should be made to the transmission data. Then, the timing in transmitting the transmission data is mediated, based on the data type information which is included in the transmission request data that is created by the transmission-request data creating means and the communication-medium type information that indicates the type of the communication medium which is stored in the type-information storing means. Sequentially, the transmission data is transmitted according to the mediated timing.

Hence, the timing in transmitting the transmission data is mediated, based on the transmission destination of the transmission data, whether or not a response should be made to the transmission data and the type of the communication medium. Therefore, several communication apparatuses which are connected to a network can communicate with each other, virtually in the form of 1:1. Thereby, while a communication is executed, its data can be prevented from colliding with another piece of data on the communication medium. This keeps the transmission data from vanishing, thus making the communication more reliable.

In this way, a communication apparatus itself has the function of mediating communication, so that it can control traffic in the system. Thus, inside of the system, it can communicate virtually in the communication form of 1:1, instead of the real communication form of m:n. This helps make communication more reliable. Besides, such a communication apparatus manages the type of data which it has received a request to transmit, and the state of that data. Every time it transmits the date, it confirms that the data can be transmitted.

According to the present invention, the timing in transmitting the transmission data is mediated, based on the transmission destination of the transmission data, whether or not a response should be made to the transmission data and the type of the communication medium. Therefore, several communication apparatuses which are connected to a network can communicate with each other, virtually in the form of 1:1. Thereby, while a communication is executed, its data can be prevented from colliding with another piece of data on the communication medium. This keeps the transmission data from vanishing, thus making the communication more reliable.

These and other objects, features and advantages of the present invention will become more apparent upon reading of the following detailed description along with the accompanied drawings.

### Brief Description of the drawings

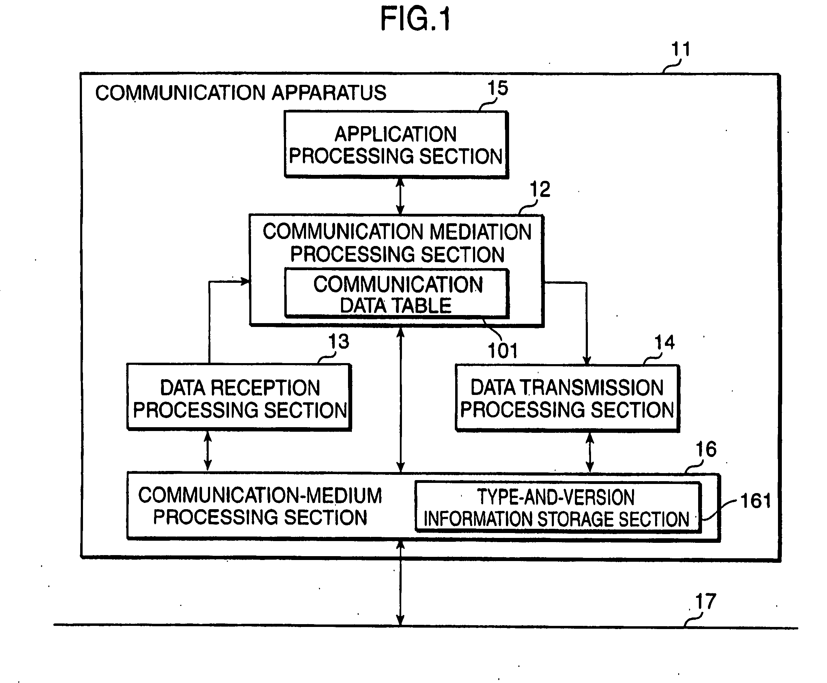

Fig. 1 is a block diagram, showing the configuration of a communication apparatus according to an embodiment of the present invention.

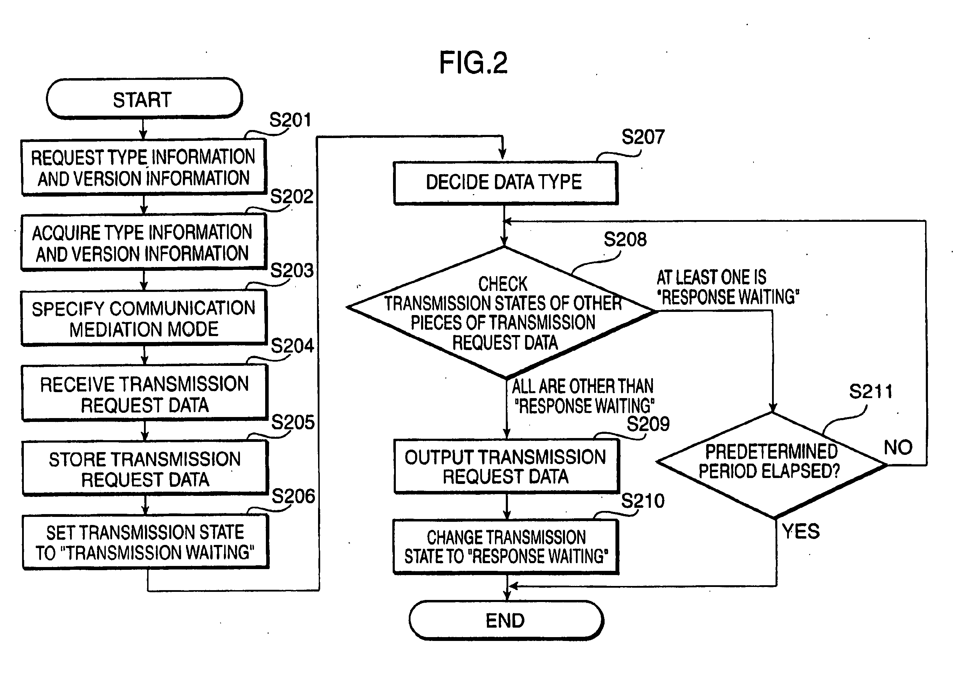

Fig. 2 is a flow chart, showing an example of a communication mediation processing which is executed by a communication mediation processing section in the case where individual response-request data is transmitted using a communication medium which is unreliable in communication and a communication-medium processing section.

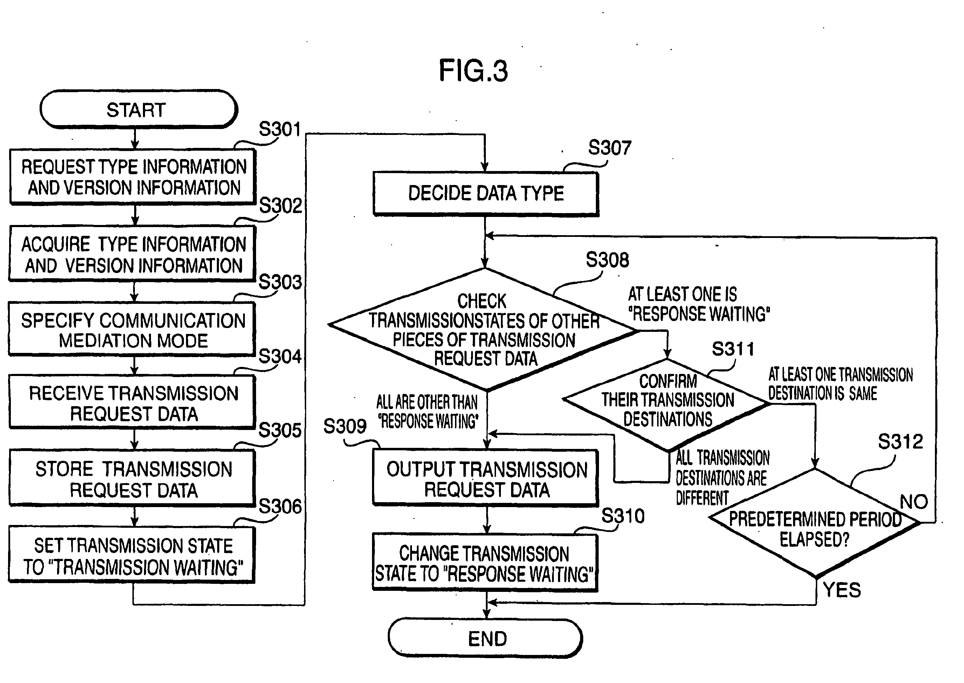

Fig. 3 is a flow chart, showing an example of a communication mediation processing which is executed by the communication mediation processing section in the case where individual response-request data is transmitted using a communication medium which is reliable in communication and the communication-medium processing section.

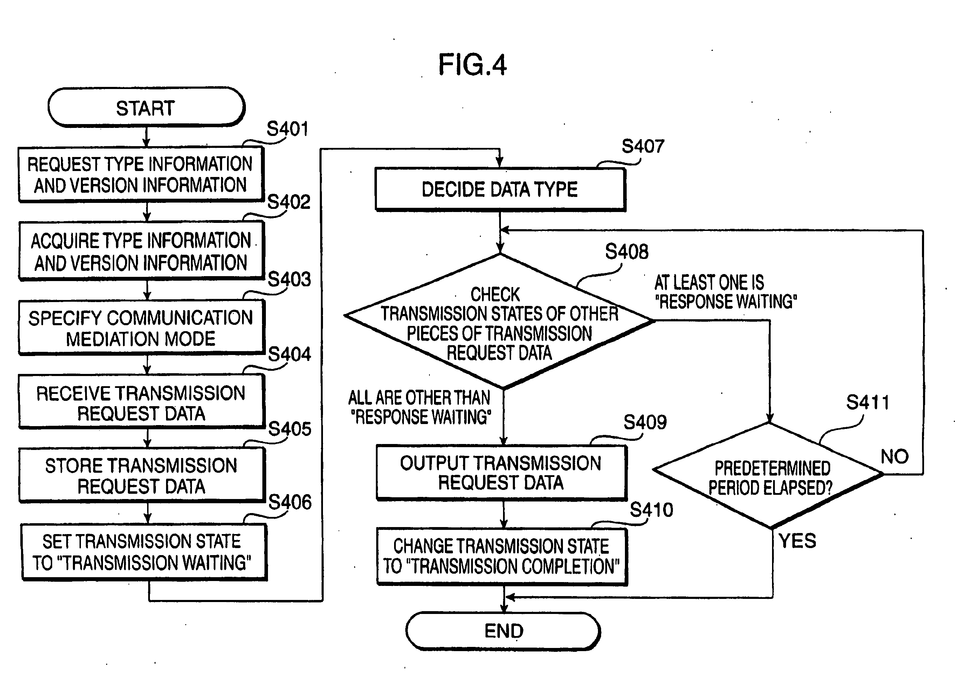

Fig. 4 is a flow chart, showing an example of a communication mediation processing which is executed by the communication mediation processing section in the case where individual no-response-request data is transmitted using a communication medium which is unreliable in communication and the communication-medium processing section.

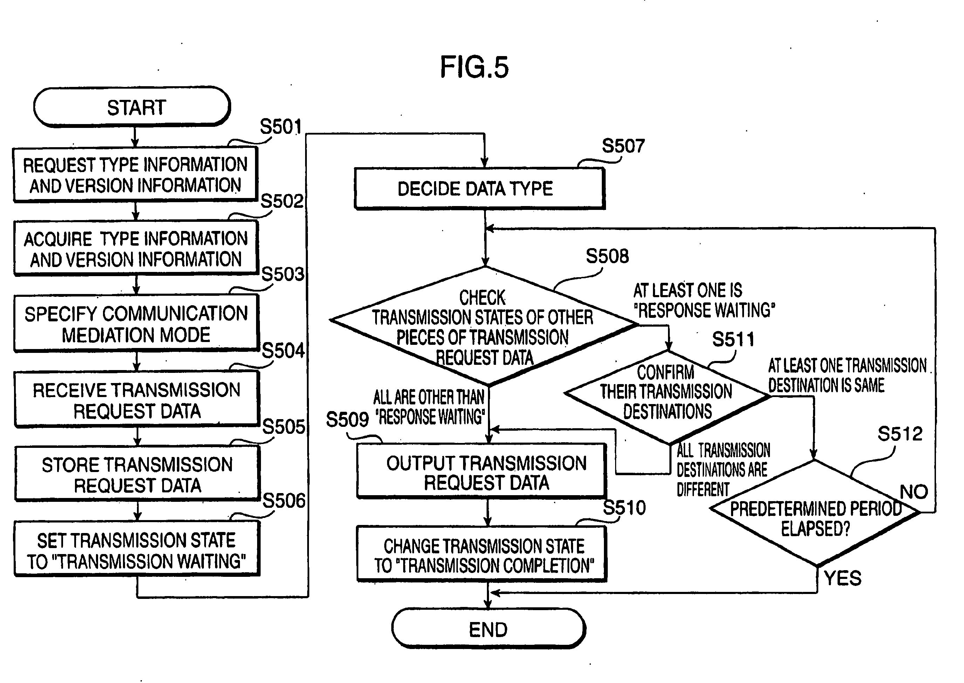

Fig. 5 is a flow chart, showing an example of a communication mediation processing which is executed by the communication mediation processing section in the case where individual no-response-request data is transmitted using a communication medium which is reliable in communication and the communication-medium processing section.

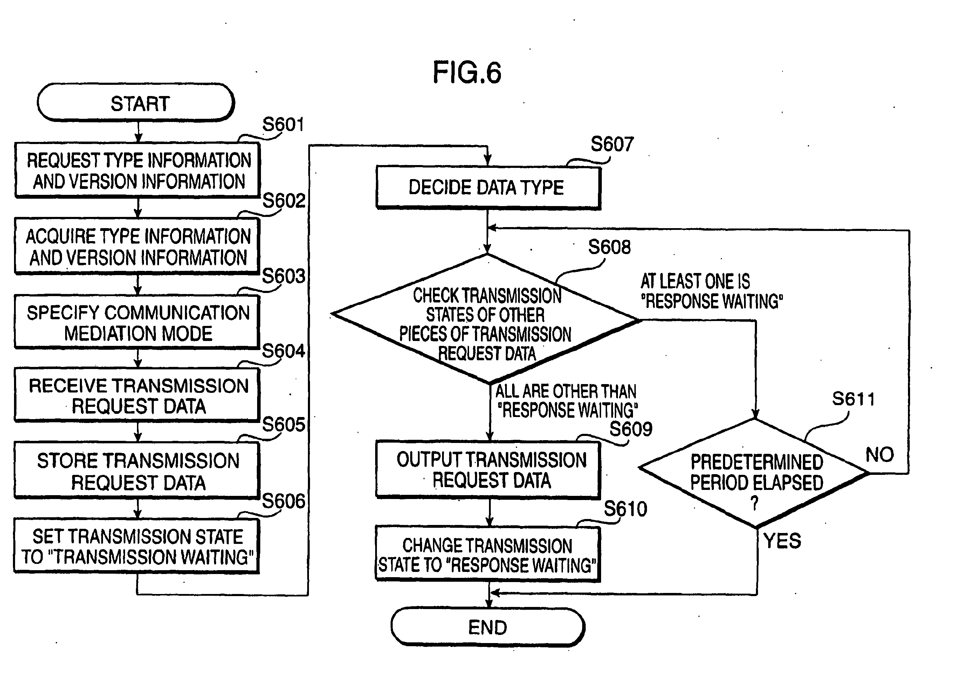

Fig. 6 is a flow chart, showing an example of a communication mediation processing which is executed by the communication mediation processing section in the case where broadcast response-request data is transmitted using a communication medium which is unreliable in communication and the communication-medium processing section.

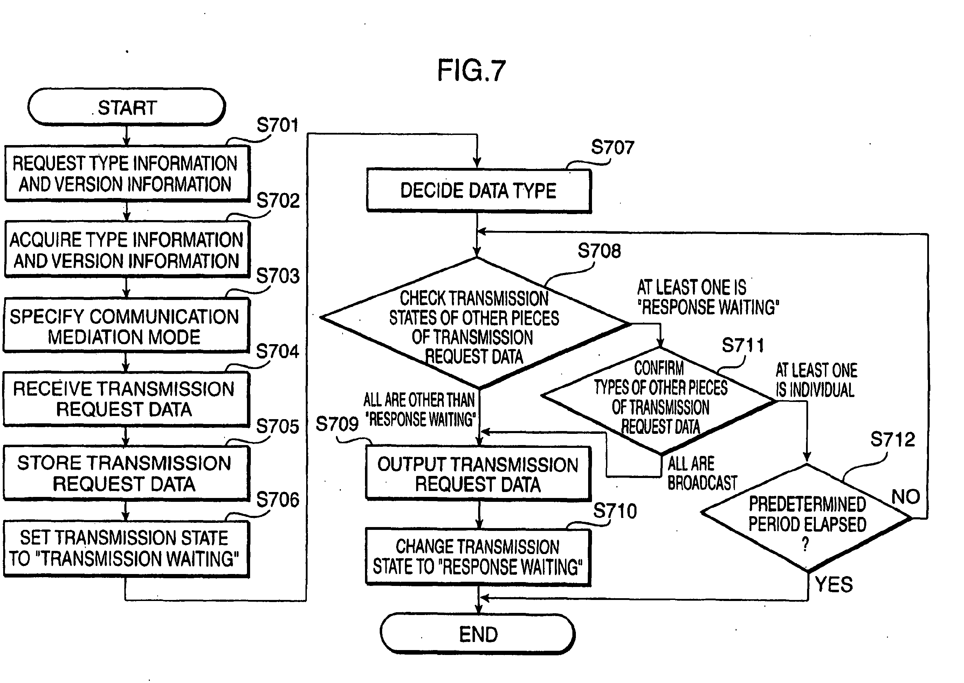

Fig. 7 is a flow chart, showing an example of a communication mediation processing which is executed by the communication mediation processing section in the case where broadcast response-request data is transmitted using a communication medium which is reliable in communication and the communication-medium processing section.

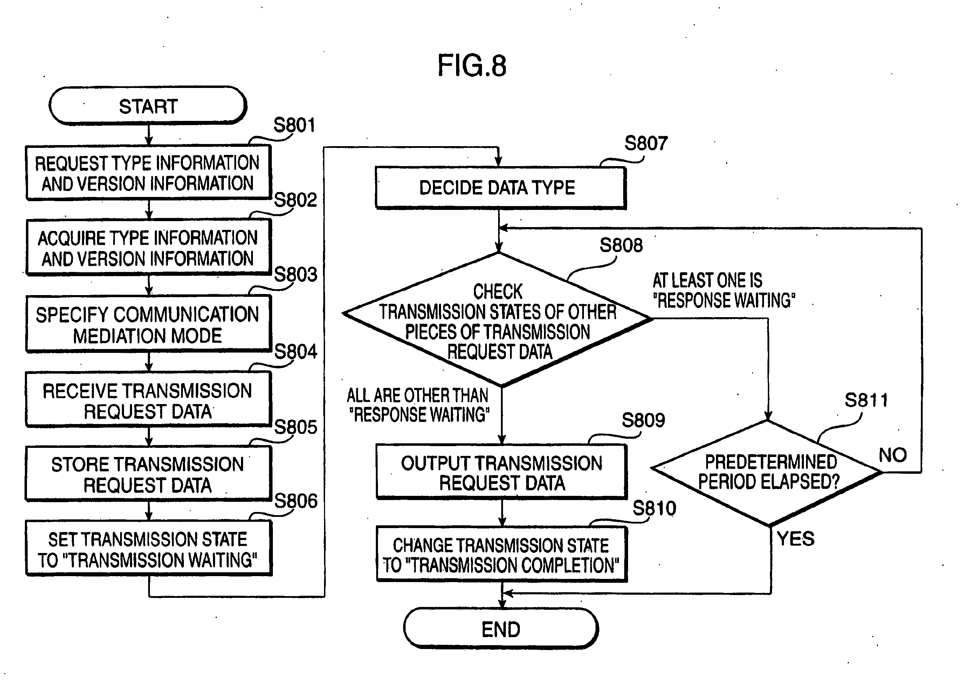

Fig. 8 is a flow chart, showing an example of a communication mediation processing which is executed by the communication mediation processing section in the case where broadcast no-response-request data is transmitted using a communication medium which is unreliable in communication and the communication-medium processing section.

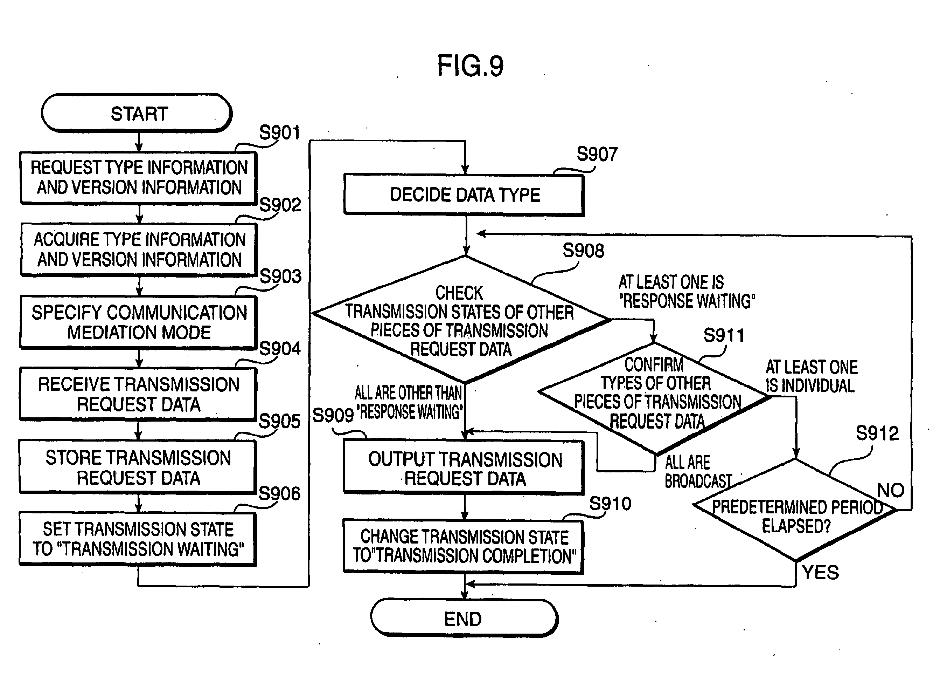

Fig. 9 is a flow chart, showing an example of a communication mediation processing which is executed by the communication mediation processing section in the case where broadcast no-response-request data is transmitted using a communication medium which is reliable in communication and the communication-medium processing section.

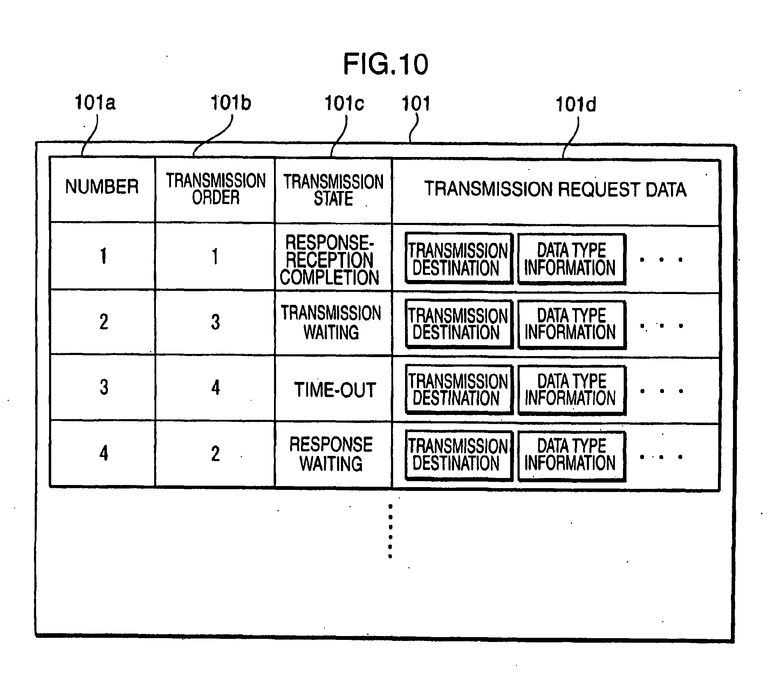

Fig. 10 is a communication data table of the communication mediation processing section, showing an example of the configuration of data.

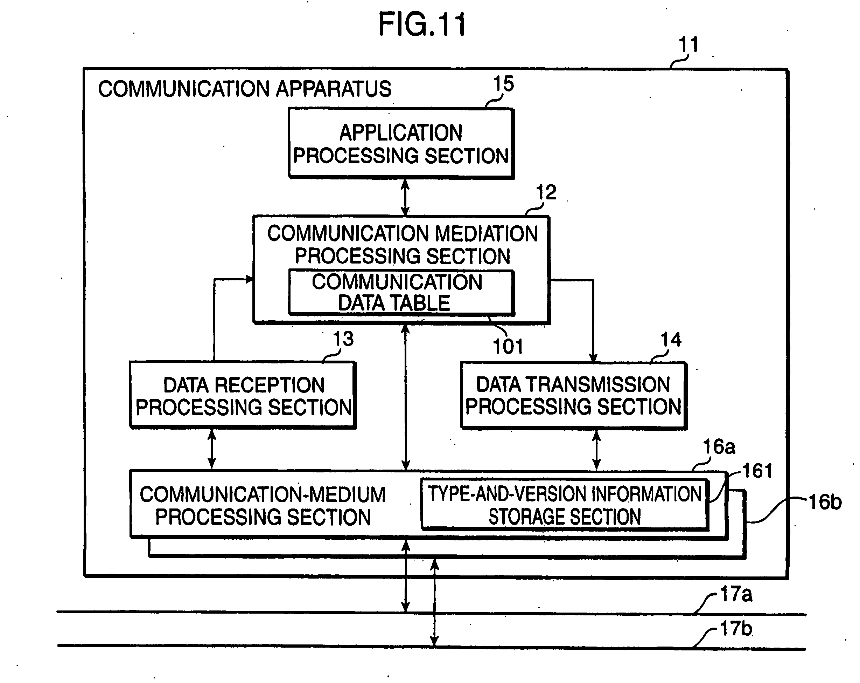

Fig. 11 is a block diagram, showing the configuration of the communication apparatus in the case where the communication apparatus is connected to a plurality of communication mediums.

### Detailed Description of Invention

Hereinafter, a communication apparatus according to an embodiment of the present invention will be described with reference to the drawings.

### (First Embodiment)

Fig. 1 is a block diagram, showing the configuration of the communication apparatus according to the embodiment of the present invention. A communication apparatus 11 is connected, via a communication medium 17, to another communication apparatus so as to communicate. In it, one or several applications are stored for its connection to the communication medium 17. The communication medium 17 is wired or radio, and for example, it is made up of a power line, a specific low-power radio, Bluetooth, and the like. In Fig. 1, the communication apparatus 11 is configured by: a communication mediation processing section 12; a data reception processing section 13; a data transmission processing section 14; an application processing section 15; and a communication-medium processing section 16.

The communication-medium processing section 16 transmits transmission data to the communication medium 17, and receives reception data from the communication medium 17. In addition, the communication-medium processing section 16 includes a type-and-version information storage section 161 in which there are stored communication-medium type information which indicates the type of the communication medium 17 and version information which indicates the version of the communication-medium processing section 16. The communication-medium processing section 16 receives, from the communication mediation processing section 12 (described later), a type-and-version information acquisition request to acquire the type of the communication medium 17 and the version of the communication-medium processing section 16. In response, it sends the communication-medium type information and the version information to the communication mediation processing section 12.

The application processing section 15 creates transmission request data which includes data type information that indicates the transmission destination of transmission data to be transmitted and whether or not a response should be made to the transmission data. Then, the application processing section 15 outputs the transmission request data it has created, in a specific timing, to the communication mediation processing section 12 (described later). In the transmission-request data, data type information is included which indicates: "individual response-request data" which designates a specific transmission destination individually and requests a response from the transmission destination of the data; "individual no-response-request data" which designates a specific transmission destination individually and does not request a response from the transmission destination of the data; "broadcast response-request data" which transmits the data broadcast without specifying a transmission destination and requests a response from the transmission destination of the data; or "broadcast no-response-request data" which transmits the data broadcast without specifying a transmission destination and does not request a response from the transmission destination of the data.

In the data transmission processing section 14, the transmission request data is inputted from the communication mediation processing section 12 (described later). Then, it makes up communication data which is conformable to a communication protocol and outputs it to the communication-medium processing section 16. The data reception processing section 13 receives reception data from the communication-medium processing section 16 and outputs the data to the communication mediation processing section 12 (described later).

The communication mediation processing section 12 asks the communication-medium processing section 16 for communication-medium type information on the communication medium 17 which is connected to the communication apparatus 11 and version information on the communication-medium processing section 16. The communication mediation processing section 12 receives the communication-medium type information and the version information from the communication-medium processing section 16. Then, it chooses a communication mediation mode (described later) which is suitable for the type of the communication medium 17 and the version of the communication-medium processing section 16. Sequentially, it mediates the timing in outputting the transmission request data to the data transmission processing section 14, so that the communication becomes reliable. Besides, the communication mediation processing section 12 expands and stores, in a communication data table 101, the transmission request data it has received from the application processing section 15.

Herein, the application processing section 15 according to this embodiment corresponds to an example of the transmission-request data creating means; the data transmission processing section 14 and the communication-medium processing section 16, an example of the data transmitting means; the communication mediation processing section 12, an example of the communication mediation processing means; and the type-and-version information storage section 161, an example of the communication-medium type-information storing means.

Fig. 10 shows an example of a communication data table. The communication data table 101 is made up of a number 101a, a transmission order 101b, a transmission state 101c and a transmission request data 101d. The number 101a indicates an order in which an input is executed in the communication mediation processing section 12. The transmission order 101b indicates an order in which a transmission is executed. The transmission state 101c indicates a transmission state at present of transmission request data. The transmission request data 101d indicates transmission request datawhich is inputted from the application processing section 15. It includes a transmission destination, data type information and the like.

In addition, the transmission data which is transmitted by the communication apparatus 11 includes four types of data: "individual response-request data" which designates a specific transmission destination individually and requests a response from the transmission destination of the data; "individual no-response-request data" which designates a specific transmission destination individually and does not request a response from the transmission destination of the data; "broadcast response-request data" which transmits the data broadcast without specifying a transmission destination and requests a response from the transmission destination of the data; and "broadcast no-response-request data" which transmits the data broadcast without specifying a transmission destination and does not request a response from the transmission destination of the data. The transmission request data includes data type information for distinguishing these types of data. In other words, the data type information is information for specifying which the transmission data is of "individual response-request data", "individual no-response-request data", "broadcast response-request data", and "broadcast no-response-request data".

Furthermore, the communication mediation processing section 12 sets the transmission state of the transmission request data in store to any of five states: a "transmission waiting state", a "response waiting state", a "time-out state", a "response-reception completion state" and a "transmission completion state". The "transmission waiting state" is a state in which the transmission request data is not yet outputted to the data transmission processing section 14 after it has been stored in the communication data table 101 of the communication mediation processing section 12. The "response waiting state" is a state in which response data to be received by the data reception processing section 13 is not yet inputted after the transmission request data has been outputted to the data transmission processing section 14. The "time-out state" is a state in which the response data is not yet inputted, even though a predetermined period of time passes after the transmission request data has been outputted to the data transmission processing section 14. The "response-reception completion state" is a state in which the response data has been inputted from the data reception processing section 13. The "transmission completion state" is a state in which if no response is required from the transmission destination, the transmission request data has been outputted to the data transmission processing section 14.

As described above, if the transmission-request data is inputted, the data type information which is included in the transmission-request data is stored in the communication data table 101, and the transmission state is set to a transmission waiting state. Then, if the stored data type information is the individual response-request data or the broadcast response-request data, after the transmission-request data is transmitted, the transmission state which corresponds to the transmitted transmission-request data is changed into a response waiting state. Sequentially, if no response is made even though a predetermined period of time elapses after the transmission state is changed into the response waiting state, the transmission state into a time-out state is changed.

Hence, if no response has been made since the transmission state was shifted into the response waiting state, even though a predetermined period of time has elapsed, then it is shifted into a time-out state without waiting for a response. This makes it possible to continue executing the processing without stopping it, even if there is no response.

Hence, according to this embodiment, the predetermined period of time when the transmission state is shifted from the response waiting state into the time-out state, is set to a time which is decided in advance. However, the present invention is not limited especially to this. It may also be set according to the communication-medium type information on the communication medium 17 which is stored in the type-and-version information storage section 161.

In this way, the predetermined period from the time when the transmission state is changed into the response waiting state to the time when the transmission state is shifted into the time-out state, is set according to the communication-medium type information which is stored in the type-and-version information storage section 161. Hence, the predetermined period during which the response waiting state is shifted into the time-out state, can be set according to the speed at which the communication medium 17 transmits data. Specifically, if the communication medium 17 transmits data fast, the predetermined period is set short. Thereby, the speed at which a communication processing is executed becomes higher. On the other hand, if the communication medium 17 transmits data slowly, the predetermined period is set long. This makes communication more reliable.

Furthermore, the predetermined period may also be set according to the data length of the transmission-request data. In that case, the predetermined period from the time when the transmission state is changed into the response waiting state to the time when the transmission state is shifted into the time-out state, is set according to the data length of the transmission-request data. Hence, the predetermined period during which the response waiting state is shifted into the time-out state, can be set according to the time which is taken for the communication medium 17 to transmit data. Specifically, if the data length of transmission-request data is short, the time which is taken to transmit it becomes short. Thus, the predetermined period is set short, so that the speed of a communication processing becomes higher. On the other hand, if the data length of transmission-request data is long, the time which is taken to transmit it becomes long. Thus, the predetermined period is set long, so that communication becomes more reliable.

Moreover, the data length of response data to the transmission data may also be predicted, so that the predetermined period can be set according to the data length of the predicted response data. In that case, the predetermined period from the time when the transmission state is changed into the response waiting state to the time when the transmission state is shifted into the time-out state, is set according to the data length of response data to the transmission data. Hence, the predetermined period during which the response waiting state is shifted into the time-out state, can be set according to the time which is taken for a communication medium to transmit the response data. Specifically, if the data length of response data is short, the time which is taken to transmit it becomes short. Thus, the predetermined period is set short, so that the speed of a communication processing becomes higher. On the other hand, if the data length of response data is long, the time which is taken to transmit it becomes long. Thus, the predetermined period is set long, so that communication becomes more reliable.

Next, a communication mediation mode will be described. In this embodiment, if the communication-medium processing section 16 has the function of detecting data colliding and preventing it from colliding on the communication medium 17, a first communication mediation mode is chosen. Unless it has such a function, a second communication mediation mode is chosen. For example, in the first communication mediation mode, before transmitting data, the communication-medium processing section 16 confirms there is no other data on the communication path of the communication medium 17. Then, if there is no other data on the communication path, after a random time or a certain time which is peculiar to equipment passes, it confirms again there is no other data on the communication path. Thereafter, it transmits the data. If the communication-medium processing section 16 has this function, the data is transmitted without colliding to the transmission destination. This makes the communication highly reliable. In contrast, in the second communication mediation mode, before transmitting data, the communication-medium processing section 16 has no such function, as described above, of detecting data colliding and preventing it from colliding. Therefore, the data is more likely to collide with another piece of data, thus making the communication less reliable.

Herein, the confirmation is obtained that there is no data on the communication path, and thereafter, the data may be transmitted. However, if there is data on the communication path, several communication apparatuses may be waiting for an opportunity to transmit their data. Thus, if they transmit the data immediately after data has disappeared from the communication path, some communication apparatuses can transmit the data simultaneously. This may cause the data to collide with each other, and thereby, to be damaged. Therefore, in this embodiment, before data is transmitted, the confirmation is obtained there is no other data on the communication path of the communication medium 17. Then, if there is no other data on the communication path, after a random time or a certain time which is peculiar to equipment passes, the confirmation is again executed that there is no other data on the communication path. Afterward, the data is transmitted. Thereby, several communication apparatuses can be prevented from transmitting the data simultaneously. This helps keep the data from being destroyed.

In the communication mediation processing section 12, the communication-medium type information, the version information and the communication mediation mode are stored beforehand, so that they correspond to each other. In other words, only if the communication mediation processing section 12 obtains the type of the communication medium 17 and the version of the communication-medium processing section 16, the communication mediation processing section 12 can decide whether or not the communication medium 17 and the communication-medium processing section 16 have the above described collision-detecting and collision-evading functions. The communication mediation processing section 12 switches the communication mediation mode which corresponds to the type of the communication medium 17 and the version information on the communication-medium processing section 16 which have been acquired from the communication-medium processing section 16. Specifically, if the communication-medium processing section 16 and the communication medium 17 have the function of detecting data colliding or preventing it from colliding on the communication medium 17, and thus, they are reliable in communication, then the communication mediation processing section 12 executes each communication mediation processing (described later) shown in Fig. 3, Fig. 5, Fig. 7 and Fig. 9. On the other hand, if the communication-medium processing section 16 and the communication medium 17 have no such function of detecting data colliding or preventing it from colliding on the communication medium 17, and thus, they are unreliable in communication, then the communication mediation processing section 12 executes each communication mediation processing (described later) shown in Fig. 2, Fig. 4, Fig. 6 and Fig. 8.

Fig. 2 is a flow chart, showing an example of a communication mediation processing which is executed by the communication mediation processing section 12, in the case where the communication medium 17 and the communication-medium processing section 16 which are unreliable in communication are used, and the data type of transmission data to be transmitted is the "individual response-request data".

First, the communication mediation processing section 12 outputs, to the communication-medium processing section 16, a type-and-version information request to acquire the communication-medium type information and the version information (in a step S201). If the type-and-version information request is inputted, the communication-medium processing section 16 reads the communication-medium type information and the version information which are stored in the type-and-version information storage section 161. Then, it outputs them to the communication mediation processing section 12. Next, the communication mediation processing section 12 acquires the communication-medium type information and the version information which have been outputted from the communication-medium processing section 16 (in a step S202).

Next, based on the communication-medium type information and the version information which it has acquired from the communication-medium processing section 16, the communication mediation processing section 12 specifies the communication mediation mode (in a step S203). In other words, the communication mediation processing section 12 chooses the communication mediation mode which corresponds to the communication-medium type information and the version information. Herein, in Fig. 2, description is given in the case where the communication-medium processing section 16 does not have the function of detecting data colliding and preventing it from colliding, and the second communication mediation mode which is less reliable in communication is chosen.

In addition, the processing of the steps S201 to S203 in Fig. 2 can only be executed when the communication apparatus 11 starts to operate. At the time when it starts, the processing of the steps S201 to S203 is executed only once. Thereafter, every time the transmission request data is received, the processing of the step S204 and the following steps is executed.

Next, the communication mediation processing section 12 receives transmission request data which is created by the application processing section 15 (in a step S204). Then, the communication mediation processing section 12 stores, in the communication data table 101, the transmission request data which it has received from the application processing section 15 (in a step S205). Sequentially, the communication mediation processing section 12 sets, to the "transmission waiting state", the transmission state which corresponds to the transmission request data that it has stored in the communication data table 101 (in a step S206).

Next, the communication mediation processing section 12 decides the type of the transmission data, based on data type information which is included in the transmission request data that it has stored in the communication data table 101 (in a step S207). Herein, at the step S207 of Fig. 2, the communication mediation processing section 12 is assumed to have decided that the data type of the transmission data is the "individual response-request data".

Next, the communication mediation processing section 12 checks the transmission states of the other pieces of transmission request data which are stored in the communication data table 101 (in a step S208). At this time, if all the transmission states of the other pieces of transmission request data are states other than the state of "response waiting" , the communication mediation processing section 12 outputs the transmission request data to the data transmission processing section 14 (in a step S209). Sequentially, the communication mediation processing section 12 changes, into the state of "response waiting", the transmission state of the transmission request data which is stored in the communication data table 101 (in a step S210).

On the other hand, if at least one of the transmission states of the other pieces of transmission request data is the state of "response waiting", the communication mediation processing section 12 decides whether or not a predetermined period of time has elapsed (in a step S211). Herein, if the decision is made that the predetermined period of time has elapsed (YES at the step S211), the communication mediation processing is terminated. On the other hand, if the decision is made that the predetermined period of time has not elapsed (NO at the step S211), the processing returns to the step S208. Then, the transmission states of the other pieces of transmission request data are checked again.

As described above, the transmission request data is created which includes data type information that indicates a transmission destination of transmission data to be transmitted and whether or not a response should be made to the transmission data. Then, the timing in transmitting the transmission data is mediated, based on the data type information which is included in the transmission request data and the communication-medium type information that indicates the type of the communication medium 17 which is stored in the type-and-version information storage section 161. Sequentially, the transmission data is transmitted according to the mediated timing.

Hence, the timing in transmitting the transmission data is mediated, based on the transmission destination of the transmission data, whether or not a response should be made to the transmission data and the type of the communication medium 17. Therefore, the several communication apparatuses 11 which are connected to a network can communicate with each other, virtually in the form of 1:1. Thereby, while a communication is executed, its data can be prevented from colliding with another piece of data on the communication medium 17. This keeps the transmission data from vanishing, thus making the communication more reliable.

In addition, a confirmation is obtained whether the data type information is the individual response-request data, the individual no-response-request data, the broadcast response-request data or the broadcast no-response-request data. This makes it possible to easily specify the transmission destination of the data and whether or not the response should be made.

Furthermore, in the communication data table 101 for managing the transmission-request data, each piece of transmission-request data should be stored so as to correspond to a transmission state. Then, the timing in transmitting the transmission data is mediated, based on the data type information which is included in the transmission request data, the communication-medium type information which is stored in the type-and-version information storage section 161, and the transmission state which is stored in the communication data table 101. Hence, the timing in transmitting the transmission data is mediated, taking into account, not only the data type information and the communication-medium type information, but also the transmission state of the transmission request data. This helps make the communication more reliable.

Moreover, if the transmission-request data is inputted, the data type information which is included in the transmission-request data is stored in the communication data table 101, and the transmission state is set to a transmission waiting state. Then, if the data type information is the individual response-request data, the transmission states are confirmed of the other pieces of transmission-request data which are stored in the communication data table 101. Herein, if the transmission states of all the other pieces of transmission-request data are not in a response waiting state, the transmission-request data is outputted to the data transmission processing section 14, and the transmission state of the transmission-request data which is stored in the communication data table 101 is changed into the response waiting state.

Hence, if the data type information is the individual response-request data, the transmission-request data is transmitted when the transmission states of all the other pieces of transmission-request data are not in a response waiting state. Therefore, the confirmation can be obtained there is no response data to another piece of transmission data on the communication medium 17. This prevents the data from colliding with another piece of data.

Fig. 3 is a flow chart, showing an example of a communication mediation processing which is executed by the communication mediation processing section 12, in the case where the communication medium 17 and the communication-medium processing section 16 which are reliable in communication are used, and the data type of transmission data to be transmitted is the " individual response-request data" . Herein, the processing of steps S301 to S306 is the same as the processing of the steps S201 to S206 in Fig. 2, and thus, its description is omitted. Besides, in the step S303 of Fig. 3, description is given in the case where the communication-medium processing section 16 has the function of detecting data colliding and preventing it from colliding, and the first communication mediation mode which is more reliable in communication is chosen. In addition, the processing of the steps S301 to S303 in Fig. 3 can only be executed when the communication apparatus 11 starts to operate. At the time when it starts, the processing of the steps S301 to S303 is executed only once. Thereafter, every time the transmission request data is received, the processing of the step S304 and the following steps is executed.

The communication mediation processing section 12 decides the type of the transmission data, based on data type information which is included in the transmission request data that it has stored in the communication data table 101 (in a step S307). Herein, at the step S307 of Fig. 3, the communication mediation processing section 12 is assumed to have decided that the data type of the transmission data is the "individual response-request data".

Next, the communication mediation processing section 12 checks the transmission states of the other pieces of transmission request datawhich are stored in the communication data table 101 (in a step S308). At this time, if all the transmission states of the other pieces of transmission request data are states other than the state of "response waiting", the communication mediation processing section 12 outputs the transmission request data to the data transmission processing section 14 (in a step S309). Sequentially, the communication mediation processing section 12 changes, into the state of "response waiting", the transmission state of the transmission request data which is stored in the communication data table 101 (in a step S310).

On the other hand, if at least one of the transmission states of the other pieces of transmission request data is the state of "response waiting", the communication mediation processing section 12 confirms the transmission destination of the transmission request data in the state of "response waiting" (in a step S311). At this time, if the transmission destination of the transmission request data to be transmitted is different from the transmission destination of all the pieces of transmission request data which stay in the state of "response waiting", the processing shifts to the step S309. Then, the communication mediation processing section 12 outputs the transmission request data to the data transmission processing section 14. Sequentially, it changes, into the state of "response waiting", the transmission state of the transmission request data which is stored in the communication data table 101.

On the other hand, if at least one of the transmission destinations of all the pieces of transmission request data which stay in the state of "response waiting" is the same as the transmission destination of the transmission request data to be transmitted, then the communication mediation processing section 12 decides whether or not a predetermined period of time has elapsed (in a step S312). Herein, if the decision is made that the predetermined period of time has elapsed (YES at the step S312), the communication mediation processing is terminated. On the other hand, if the decision is made that the predetermined period of time has not elapsed (NO at the step S312), the processing returns to the step S308. Then, the transmission states of the other pieces of transmission request data are checked again.

In this way, according to communication reliability, the processing is automatically switched from Fig. 2 to Fig. 3, and vice versa. This presents an advantage in that communication processing can be executed at the highest speed within the range where a reliable communication can be realized in the entire system.

Furthermore, the communication-medium processing section 16 has the function of transmitting the transmission data, after confirming there is not another piece of data on the communication path of the communication medium 17 before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table 101, and the transmission state is set to a transmission waiting state. Then, if the stored data type information is the individual response-request data, when the transmission states of all the other pieces of transmission-request data are not in a response waiting state, or when the transmission states of some of the other pieces of transmission-request data are in the response waiting state and all the transmission destinations of some of the other pieces of transmission-request data which are in the response waiting state are different from the transmission destination of the transmission-request data, the transmission-request data is outputted to the data transmission processing section 14, and the transmission state of the transmission-request data which is stored in the communication data table 101 is changed into the response waiting state.

Hence, if the communication medium 17 has the function of preventing data from colliding and the data type information is the individual response-request data, the data is transmitted when the transmission destination of the transmission data is different from the transmission origin of the response data. This prevents the data from colliding.

Fig. 4 is a flow chart, showing an example of a communication mediation processing which is executed by the communication mediation processing section 12, in the case where the communication medium 17 and the communication-medium processing section 16 which are unreliable in communication are used, and the data type of transmission data to be transmitted is the "individual no-response-request data". Herein, the processing of steps S401 to S406 is the same as the processing of the steps S201 to S206 in Fig. 2, and thus, its description is omitted. Besides, in the step S403 of Fig. 4, description is given in the case where the communication-medium processing section 16 does not have the function of detecting data colliding and preventing it from colliding, and the second communication mediation mode which is less reliable in communication is chosen. In addition, the processing of the steps S401 to S403 in Fig. 4 can only be executed when the communication apparatus 11 starts to operate. At the time when it starts, the processing of the steps S401 to S403 is executed only once. Thereafter, every time the transmission request data is received, the processing of the step S404 and the following steps is executed.

The communication mediation processing section 12 decides the type of the transmission data, based on data type information which is included in the transmission request data that it has stored in the communication data table 101 (in a step S407). Herein, at the step S407 of Fig. 4, the communication mediation processing section 12 is assumed to have decided that the data type of the transmission data is the "individual no-response-request data".

Next, the communication mediation processing section 12 checks the transmission states of the other pieces of transmission request data which are stored in the communication data table 101 (in a step S408). At this time, if all the transmission states of the other pieces of transmission request data are states other than the state of "response waiting", the communication mediation processing section 12 outputs the transmission request data to the data transmission processing section 14 (in a step S409). Sequentially, the communication mediation processing section 12 changes, into the state of "transmission completion", the transmission state of the transmission request data which is stored in the communication data table 101 (in a step S410).

On the other hand, if at least one of the transmission states of the other pieces of transmission request data is the state of "response waiting", the communication mediation processing section 12 decides whether or not a predetermined period of time has elapsed (in a step S411). Herein, if the decision is made that the predetermined period of time has elapsed (YES at the step S411), the communication mediation processing is terminated. On the other hand, if the decision is made that the predetermined period of time has not elapsed (NO at the step S411), the processing returns to the step S408. Then, the transmission states of the other pieces of transmission request data are checked again.

As described above, if the transmission-request data is inputted, the data type information which is included in the transmission-request data is stored in the communication data table 101, and the transmission state is set to a transmission waiting state. Then, if the stored data type information is the individual no-response-request data, when the transmission states of all the other pieces of transmission-request data are not in a response waiting state, the transmission-request data is outputted to the data transmission processing section 14, and the transmission state of the transmission-request data which is stored in the communication data table 101 is changed into a transmission completion state.

Hence, if the data type information is the individual no-response-request data, the transmission-request data is transmitted when the transmission states of all the other pieces of transmission-request data are not in a response waiting state. Therefore, the confirmation can be obtained there is no response data to another piece of transmission data on the communication medium 17. This prevents the data from colliding.

Fig. 5 is a flow chart, showing an example of a communication mediation processing which is executed by the communication mediation processing section 12, in the case where the communication medium 17 and the communication-medium processing section 16 which are reliable in communication are used, and the data type of transmission data to be transmitted is the "individual no-response-request data". Herein, the processing of steps S501 to S506 is the same as the processing of the steps S201 to S206 in Fig. 2, and thus, its description is omitted. Besides, in the step S503 of Fig. 5, description is given in the case where the communication-medium processing section 16 has the function of detecting data colliding and preventing it from colliding, and the first communication mediation mode which is more reliable in communication is chosen. In addition, the processing of the steps S501 to S503 in Fig. 5 can only be executed when the communication apparatus 11 starts to operate. At the time when it starts, the processing of the steps S501 to S503 is executed only once. Thereafter, every time the transmission request data is received, the processing of the step S504 and the following steps is executed.

The communication mediation processing section 12 decides the type of the transmission data, based on data type information which is included in the transmission request data that it has stored in the communication data table 101 (in a step S507). Herein, at the step S507 of Fig. 5, the communication mediation processing section 12 is assumed to have decided that the data type of the transmission data is the "individual no-response-request data".

Next, the communication mediation processing section 12 checks the transmission states of the other pieces of transmission request data which are stored in the communication data table 101 (in a step S508). At this time, if all the transmission states of the other pieces of transmission request data are states other than the state of "response waiting", the communication mediation processing section 12 outputs the transmission request data to the data transmission processing section 14 (in a step S509). Sequentially, the communication mediation processing section 12 changes, into the state of "transmission completion", the transmission state of the transmission request data which is stored in the communication data table 101 (in a step S510).

On the other hand, if at least one of the transmission states of the other pieces of transmission request data is the state of "response waiting", the communication mediation processing section 12 confirms the transmission destination of the transmission request data in the state of "response waiting" (in a step S511). At this time, if the transmission destination of the transmission request data to be transmitted is different from the transmission destination of all the pieces of transmission request data which stay in the state of "response waiting", the processing shifts to the step S509. Then, the communication mediation processing section 12 outputs the transmission request data to the data transmission processing section 14. Sequentially, it changes, into the state of "transmission completion" , the transmission state of the transmission request data which is stored in the communication data table 101.

On the other hand, if at least one of the transmission destinations of all the pieces of transmission request data which stay in the state of "response waiting" is the same as the transmission destination of the transmission request data to be transmitted, then the communication mediation processing section 12 decides whether or not a predetermined period of time has elapsed (in a step S512). Herein, if the decision is made that the predetermined period of time has elapsed (YES at the step S512), the communication mediation processing is terminated. On the other hand, if the decision is made that the predetermined period of time has not elapsed (NO at the step S512), the processing returns to the step S508. Then, the transmission states of the other pieces of transmission request data are checked again.

In this way, according to communication reliability, the processing is automatically switched from Fig. 4 to Fig. 5, and vice versa. This presents an advantage in that communication processing can be executed at the highest speed within the range where a reliable communication can be realized in the entire system.

In addition, the communication-medium processing section 16 has the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table 101, and the transmission state is set to a transmission waiting state. Then, if the stored data type information is the individual no-response-request data, when the transmission states of all the other pieces of transmission-request data are not in a response waiting state, or when the transmission states of some of the other pieces of transmission-request data are in the response waiting state and all the transmission destinations of some of the other pieces of transmission-request data which are in the response waiting state are different from the transmission destination of the transmission-request data, the transmission-request data is outputted to the data transmission processing section 14, and the transmission state of the transmission-request data which is stored in the communication data table 101 is changed into the transmission completion state.

Hence, if the communication medium has the function of preventing data from colliding and the data type information is the individual no-response-request data, the data is transmitted when the transmission destination of the transmission data is different from the transmission origin of the response data. This prevents the data from colliding.

Fig. 6 is a flow chart, showing an example of a communication mediation processing which is executed by the communication mediation processing section 12, in the case where the communication medium 17 and the communication-medium processing section 16 which are unreliable in communication are used, and the data type of transmission data to be transmitted is the "broadcast response-request data". Herein, the processing of steps S601 to S606 is the same as the processing of the steps S201 to S206 in Fig. 2, and thus, its description is omitted. Besides, in the step S603 of Fig. 6, description is given in the case where the communication-medium processing section 16 does not have the function of detecting data colliding and preventing it from colliding, and the second communication mediation mode which is less reliable in communication is chosen. In addition, the processing of the steps S601 to S603 in Fig. 6 can only be executed when the communication apparatus 11 starts to operate. At the time when it starts, the processing of the steps S601 to S603 is executed only once. Thereafter, every time the transmission request data is received, the processing of the step S604 and the following steps is executed.

The communication mediation processing section 12 decides the type of the transmission data, based on data type information which is included in the transmission request data that it has stored in the communication data table 101 (in a step S607). Herein, at the step S607 of Fig. 6, the communication mediation processing section 12 is assumed to have decided that the data type of the transmission data is the "broadcast response-request data".

Next, the communication mediation processing section 12 checks the transmission states of the other pieces of transmission request data which are stored in the communication data table 101 (in a step S608). At this time, if all the transmission states of the other pieces of transmission request data are states other than the state of "response waiting", the communication mediation processing section 12 outputs the transmission request data to the data transmission processing section 14 (in a step S609). Sequentially, the communication mediation processing section 12 changes, into the state of "response waiting", the transmission state of the transmission request data which is stored in the communication data table 101 (in a step S610).

On the other hand, if at least one of the transmission states of the other pieces of transmission request data is the state of "response waiting", the communication mediation processing section 12 decides whether or not a predetermined period of time has elapsed (in a step S611). Herein, if the decision is made that the predetermined period of time has elapsed (YES at the step S611), the communication mediation processing is terminated. On the other hand, if the decision is made that the predetermined period of time has not elapsed (NO at the step S611), the processing returns to the step S608. Then, the transmission states of the other pieces of transmission request data are checked again.

As described above, if the transmission-request data is inputted, the data type information which is included in the transmission-request data is stored in the communication data table 101, and the transmission state is set to a transmission waiting state. Then, if the stored data type information is the broadcast response-request data, when the transmission states of all the other pieces of transmission-request data are not in a response waiting state, the transmission-request data is outputted to the data transmission processing section 14, and the transmission state of the transmission-request data which is stored in the communication data table 101 is changed into the response waiting state.

Hence, if the data type information is the broadcast response-request data, the transmission-request data is transmitted when the transmission states of all the other pieces of transmission-request data are not in a response waiting state. Therefore, the confirmation can be obtained there is no response data to another piece of transmission data on the communication medium. This prevents the data from colliding.

Fig. 7 is a flow chart, showing an example of a communication mediation processing which is executed by the communication mediation processing section 12, in the case where the communication medium 17 and the communication-medium processing section 16 which are reliable in communication are used, and the data type of transmission data to be transmitted is the "broadcast response-request data". Herein, the processing of steps S701 to S706 is the same as the processing of the steps S201 to S206 in Fig. 2, and thus, its description is omitted. Besides, in the step S703 of Fig. 7, description is given in the case where the communication-medium processing section 16 has the function of detecting data colliding and preventing it from colliding, and the first communication mediation mode which is more reliable in communication is chosen. In addition, the processing of the steps S701 to S703 in Fig. 7 can only be executed when the communication apparatus 11 starts to operate. At the time when it starts, the processing of the steps S701 to S703 is executed only once. Thereafter, every time the transmission request data is received, the processing of the step S704 and the following steps is executed.

The communication mediation processing section 12 decides the type of the transmission data, based on data type information which is included in the transmission request data that it has stored in the communication data table 101 (in a step S707). Herein, at the step S707 of Fig. 7, the communication mediation processing section 12 is assumed to have decided that the data type of the transmission data is the "broadcast response-request data".

Next, the communication mediation processing section 12 checks the transmission states of the other pieces of transmission request data which are stored in the communication data table 101 (in a step S708). At this time, if all the transmission states of the other pieces of transmission request data are states other than the state of "response waiting", the communication mediation processing section 12 outputs the transmission request data to the data transmission processing section 14 (in a step S709). Sequentially, the communication mediation processing section 12 changes, into the state of "response waiting", the transmission state of the transmission request data which is stored in the communication data table 101 (in a step S710).

On the other hand, if at least one of the transmission states of the other pieces of transmission request data is the state of "response waiting", the communication mediation processing section 12 confirms the data type of the transmission request data in the state of "response waiting" (in a step S711). At this time, if the data types of all the pieces of transmission request data which stay in the state of "response waiting" are broadcast data (i.e., the broadcast response-request data), the processing shifts to the step S709. Then, the communication mediation processing section 12 outputs the transmission request data to the data transmission processing section 14. Sequentially, it changes, into the state of "response waiting", the transmission state of the transmission request data which is stored in the communication data table 101.

On the other hand, if at least one of the data types of all the pieces of transmission request data which stay in the state of "response waiting" is individual data (i.e., the individual response-request data), then the communication mediation processing section 12 decides whether or not a predetermined period of time has elapsed (in a step S712). Herein, if the decision is made that the predetermined period of time has elapsed (YES at the step S712), the communication mediation processing is terminated. On the other hand, if the decision is made that the predetermined period of time has not elapsed (NO at the step S712), the processing returns to the step S708. Then, the transmission states of the other pieces of transmission request data are checked again.

Hence, the communication-medium processing section 16 has the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table 101, and the transmission state is set to a transmission waiting state. Then, if the stored data type information is the broadcast response-request data, the transmission states of the other pieces of transmission-request data are confirmed which are stored in the communication data table. Herein, if the transmission states of all the other pieces of transmission-request data are not in a response waiting state, or if the transmission states of some of the other pieces of transmission-request data are in the response waiting state and all the types of some of the other pieces of transmission-request data which are in the response waiting state are broadcast, the transmission-request data is outputted to the data transmission processing section 14, and the transmission state of the transmission-request data which is stored in the communication data table 101 is changed into the response waiting state.

In the case of a broadcast transmission, the transmission data is transmitted to other unspecified communication apparatuses. Therefore, response data is not necessarily sent, and thus, response data may be already replied from all of other communication apparatuses. As a result, in the case of a broadcast transmission, even if the transmission data is transmitted without waiting for response data to come, the transmission data is unlikely to collide with the response data. Thus, if the communication medium 17 has the function of preventing data from colliding and the data type information is the broadcast response-request data, the data is transmitted when all the types of the pieces of transmission-request data in the response waiting state are broadcast. This prevents the data from colliding.

Fig. 8 is a flow chart, showing an example of a communication mediation processing which is executed by the communication mediation processing section 12, in the case where the communication medium 17 and the communication-medium processing section 16 which are unreliable in communication are used, and the data type of transmission data to be transmitted is the "broadcast no-response-request data". Herein, the processing of steps S801 to S806 is the same as the processing of the steps S201 to S206 in Fig. 2, and thus, its description is omitted. Besides, in the step S803 of Fig. 8, description is given in the case where the communication-medium processing section 16 does not have the function of detecting data colliding and preventing it from colliding, and the second communication mediation mode which is less reliable in communication is chosen. In addition, the processing of the steps S801 to S803 in Fig. 8 can only be executed when the communication apparatus 11 starts to operate. At the time when it starts, the processing of the steps S801 to S803 is executed only once. Thereafter, every time the transmission request data is received, the processing of the step S804 and the following steps is executed.

The communication mediation processing section 12 decides the type of the transmission data, based on data type information which is included in the transmission request data that it has stored in the communication data table 101 (in a step S807). Herein, at the step S807 of Fig. 8, the communication mediation processing section 12 is assumed to have decided that the data type of the transmission data is the "broadcast no-response-request data".

Next, the communication mediation processing section 12 checks the transmission states of the other pieces of transmission request data which are stored in the communication data table 101 (in a step S808). At this time, if all the transmission states of the other pieces of transmission request data are states other than the state of "response waiting", the communication mediation processing section 12 outputs the transmission request data to the data transmission processing section 14 (in a step S809). Sequentially, the communication mediation processing section 12 changes, into the state of "transmission completion", the transmission state of the transmission request data which is stored in the communication data table 101 (in a step S810).

On the other hand, if at least one of the transmission states of the other pieces of transmission request data is the state of "response waiting", the communication mediation processing section 12 decides whether or not a predetermined period of time has elapsed (in a step S811). Herein, if the decision is made that the predetermined period of time has elapsed (YES at the step S811), the communication mediation processing is terminated. On the other hand, if the decision is made that the predetermined period of time has not elapsed (NO at the step S811), the processing returns to the step S808. Then, the transmission states of the other pieces of transmission request data are checked again.

As described above, if the transmission-request data is inputted, the data type information which is included in the transmission-request data is stored in the communication data table 101, and the transmission state is set to a transmission waiting state. Then, if the stored data type information is the broadcast no-response-request data, when the transmission states of all the other pieces of transmission-request data are not in a response waiting state, the transmission-request data is outputted to the data transmission processing section 14, and the transmission state of the transmission-request data which is stored in the communication data table 101 is changed into the transmission completion state.

Hence, if the data type information is the broadcast no-response-request data, the transmission-request data is transmitted when the transmission states of all the other pieces of transmission-request data are not in a response waiting state. Therefore, the confirmation can be obtained there is no response data to another piece of transmission data on the communication medium. This prevents the data from colliding.

Fig. 9 is a flow chart, showing an example of a communication mediation processing which is executed by the communication mediation processing section 12, in the case where the communication medium 17 and the communication-medium processing section 16 which are reliable in communication are used, and the data type of transmission data to be transmitted is the "broadcast no-response-request data". Herein, the processing of steps S901 to S906 is the same as the processing of the steps S201 to S206 in Fig. 2, and thus, its description is omitted. Besides, in the step S903 of Fig. 9, description is given in the case where the communication-medium processing section 16 has the function of detecting data colliding and preventing it from colliding, and the first communication mediation mode which is more reliable in communication is chosen. In addition, the processing of the steps S901 to S903 in Fig. 9 can only be executed when the communication apparatus 11 starts to operate. At the time when it starts, the processing of the steps S901 to S903 is executed only once. Thereafter, every time the transmission request data is received, the processing of the step S904 and the following steps is executed.

The communication mediation processing section 12 decides the type of the transmission data, based on data type information which is included in the transmission request data that it has stored in the communication data table 101 (in a step S907). Herein, at the step S907 of Fig. 9, the communication mediation processing section 12 is assumed to have decided that the data type of the transmission data is the "broadcast no-response-request data".

Next, the communication mediation processing section 12 checks the transmission states of the other pieces of transmission request data which are stored in the communication data table 101 (in a step S908). At this time, if all the transmission states of the other pieces of transmission request data are states other than the state of "response waiting", the communication mediation processing section 12 outputs the transmission request data to the data transmission processing section 14 (in a step S909). Sequentially, the communication mediation processing section 12 changes, into the state of "transmission completion", the transmission state of the transmission request data which is stored in the communication data table 101 (in a step S910).

On the other hand, if at least one of the transmission states of the other pieces of transmission request data is the state of "response waiting", the communication mediation processing section 12 confirms the data type of the transmission request data in the state of "response waiting" (in a step S911). At this time, if the data types of all the pieces of transmission request data which stay in the state of "response waiting" are broadcast data (i.e., the broadcast response-request data), the processing shifts to the step S909. Then, the communication mediation processing section 12 outputs the transmission request data to the data transmission processing section 14. Sequentially, it changes, into the state of "transmission completion", the transmission state of the transmission request data which is stored in the communication data table 101.

On the other hand, if at least one of the data types of all the pieces of transmission request data which stay in the state of "response waiting" is individual data (i.e., the individual response-request data), then the communication mediation processing section 12 decides whether or not a predetermined period of time has elapsed (in a step S912). Herein, if the decision is made that the predetermined period of time has elapsed (YES at the step S912), the communication mediation processing is terminated. On the other hand, if the decision is made that the predetermined period of time has not elapsed (NO at the step S912), the processing returns to the step S908. Then, the transmission states of the other pieces of transmission request data are checked again.

Hence, the communication-medium processing section 16 has the function of transmitting the transmission data, after confirming there is not another piece of data on the communication path of the communication medium before the transmission data is transmitted, and if there is not another piece of data on the communication path, confirming again there is not another piece of data on the communication path after a predetermined period of time elapses. In this case, if the transmission-request data is inputted, the data type information which is included in the transmission-request data is stored in the communication data table 101, and the transmission state is set to a transmission waiting state. Then, if the stored data type information is the broadcast no-response-request data, when the transmission states of all the other pieces of transmission-request data are not in a response waiting state, or if the transmission states of some of the other pieces of transmission-request data are in the response waiting state and all the types of some of the other pieces of transmission-request data which are in the response waiting state are broadcast, the transmission-request data is outputted to the data transmission processing section 14, and the transmission state of the transmission-request data which is stored in the communication data table 101 is changed into the transmission completion state.

In the case of a broadcast transmission, the transmission data is transmitted to other unspecified communication apparatuses. Therefore, response data is not necessarily sent, and thus, response data may be already replied from all of other communication apparatuses. As a result, in the case of a broadcast transmission, even if the transmission data is transmitted without waiting for response data to come, the transmission data is unlikely to collide with the response data. Thus, if the communication medium 17 has the function of preventing data from colliding and the data type information is the broadcast no-response-request data, the data is transmitted when all the types of the pieces of transmission-request data in the response waiting state are broadcast. This prevents the data from colliding.

Herein, the communication apparatus 11 according to this embodiment is connected to the communication medium 17. However, the present invention is not limited especially to this. It may also be connected to a plurality of communication mediums which have a standard different from each other. Fig. 11 is a block diagram, showing the configuration of the communication apparatus in the case where the communication apparatus is connected to a plurality of communication mediums.

A communication apparatus 11 shown in Fig. 11 is configured by: a communication mediation processing section 12; a data reception processing section 13; a data transmission processing section 14; an application processing section 15; and a plurality of communication-medium processing sections 16a, 16b. The communication apparatus 11 is connected to another communication apparatus, via a plurality of communication mediums 17a, 17b which have a standard different from each other, so that they can communicate. In Fig. 11, description is omitted about the same configuration as that of Fig. 1. The communication apparatus 11 is provided with communication-medium processing sections according to the number of connected communication mediums. In Fig. 11, it is connected to the two communication mediums 17a, 17b. Thus, according to each communication medium 17a, 17b, it is provided with the two communication-medium processing sections 16a, 16b. The communication-medium processing sections 16a, 16b each have the same configuration as that of the communication-medium processing section 16 shown in Fig. 1, and thus, their description is omitted.

According to the communication medium to which data to be transmitted is sent, the communication mediation processing section 12 switches the communication-medium processing sections 16a, 16b. For example, the application processing section 15 creates transmission-request data which includes communication-medium specification information for specifying a communication medium to be used from among a plurality of communication mediums which have a standard different from each other. Then, it outputs the transmission-request data which it has created to the communication mediation processing section 12. Based on the communication-medium specification information which is included in the transmission-request data, the communication mediation processing section 12 specifies a communication-medium processing section to be used. Then, the data transmission processing section 14 outputs the transmission data to the communication-medium processing section which has been specified by the communication mediation processing section 12. In this way, the communication medium which transmits the data is switched and used. Thereby, the data can be transmitted, using a plurality of communication mediums which have a different standard.

Herein, in this embodiment, the application processing section 15 creates transmission-request data which includes communication-medium specification information for specifying a communication medium to be used from among a plurality of communication mediums which have a standard different from each other. However, the present invention is not limited especially to this. For example, the application processing section 15 may also create transmission-request data which includes the transmission destination of transmission data and its data type information. In that case, the data transmission processing section 14 specifies a communication medium to be used from among a plurality of communication mediums which have a standard different from each other.

In addition, the communication mediation processing according to the present invention can be realized by allowing a CPU (or central processing unit) to execute a communication mediation processing program which is stored in a ROM (or read only memory) that is provided in the communication apparatus 11. Then, the communication mediation processing program is recorded and transferred into a computer-readable record medium. This makes it possible for an independent computer system to execute the communication mediation processing.

The communication apparatus, the communication method, and the computer-readable record medium in which a communication program is recorded according to the present invention, are useful in securing communication reliability. Especially, they are advantageous in the case where a system is built up, using a communication medium which is slow and unreliable in communication at a physical layer. If such a communication apparatus is incorporated into middleware or the like, each application can be easily developed and designed, without becoming aware of a communication state. Particularly, this communication apparatus becomes more advantageous when it is incorporated into control-system equipment such as a controller, or the like.

Although the present invention has been fully described by way of example with reference to the accompanied drawings, it is to be understood that various changes and modifications will be apparent to those skilled in the art. Therefore, unless otherwise such changes and modifications depart from the scope of the present invention hereinafter defined, they should be construed as being included therein.

## Claims

1. A communication apparatus (11) which transmits and receives data to and from another communication apparatus, via a communication medium (17), comprising:
a transmission-request data creating means (15) for creating transmission request data (101d) which includes data type information that indicates a transmission destination of transmission data to be transmitted and whether or not a response should be made to the transmission data;
a communication-medium type-information storing means (161) for storing communication-medium type information that indicates the type of the communication medium (17);
a communication data table (101) for managing the transmission-request data (101d), wherein each piece of transmission-request data (101d) is stored so as to correspond to a transmission state (101c);
a communication mediation processing means (12) for determining the timing in transmitting the transmission data, based on the data type information which is included in the transmission request data (101d) that is created by the transmission-request data creating means (15), the communication-medium type information which is stored in the type-information storing means (161), and the transmission state of other pieces of transmission-request data stored in the communication data table (101); and
a data transmitting means (14, 16) for transmitting the transmission data according to the timing which is determined by the communication mediation processing means (12).

2. The communication apparatus according to claim 1,
wherein:
the transmission-request data (101d) includes data type information which indicates that the transmission data to be transmitted is: individual response-request data which designates a specific transmission destination individually and requests a response from the transmission destination of the transmission data; individual no-response-request data which designates a specific transmission destination individually and does not request a response from the transmission destination of the transmission data;
broadcast response-request data which transmits the transmission data broadcast without specifying a transmission destination and requests a response from the transmission destination of the transmission data; or
broadcast no-response-request data which transmits the transmission data broadcast without specifying a transmission destination and does not request a response from the transmission destination of the transmission data; and
the communication mediation processing means (12) determines the timing in transmitting the transmission data, based on the data type information which is included in the transmission request data (101d) that is created by the transmission-request data creating means (15) and the communication-medium type information which is stored in the communication-medium type-information storing means (161) .

3. The communication apparatus according to claim 2,
wherein the communication mediation processing means (12):
if the transmission-request data (101d) is inputted, stores, in the communication data table (101), the data type information which is included in the transmission-request data (101d), and sets the transmission state (101c) to a transmission waiting state; if the data type information is the individual response-request data, confirms the transmission states (101c) of the other pieces of transmission-request data (101d) which are stored in the communication data table (101); and if the transmission states (101c) of all the other pieces of transmission-request data (101d) are not in a response waiting state, outputs the transmission-request data (101d) to the data transmitting means (14, 16), and changes, into the response waiting state, the transmission state (101c) of the transmission-request data (101d) which is stored in the communication data table (101).

4. The communication apparatus according to claim 2,
wherein:
the data transmitting means (14, 16) has the function of transmitting the transmission data, after confirming there is not another piece of data on the communication path of the communication medium (17) before the transmission data is transmitted, and if there is not another piece of data on the communication path, confirming again there is not another piece of data on the communication path after a predetermined period of time elapses; and
the communication mediation processing means (12): if the transmission-request data (101d) is inputted, stores, in the communication data table (101), the data type information which is included in the transmission-request data (101d), and sets the transmission state (101c) to a transmission waiting state; if the data type information is the individual response-request data, confirms the transmission states (101c) of the other pieces of transmission-request data (101d) which are stored in the communication data table (101); and if the transmission states (101c) of all the other pieces of transmission-request data (101d) are not in a response waiting state, or if the transmission states (101c) of some of the other pieces of transmission-request data (101d) are in the response waiting state and all the transmission destinations of some of the other pieces of transmission-request data (101d) which are in the response waiting state are different from the transmission destination of the transmission-request data (101d), outputs the transmission-request data (101d) to the data transmitting means (14, 16), and changes, into the response waiting state, the transmission state (101c) of the transmission-request data (101d) which is stored in the communication data table (101) .

5. The communication apparatus according to claim 2,
wherein the communication mediation processing means (12):
if the transmission-request data (101d) is inputted,
stores, in the communication data table (101), the data type information which is included in the transmission-request data (101d), and sets the transmission state (101c) to a transmission waiting state; if the data type information is the individual no-response-request data, confirms the transmission states (101c) of the other pieces of transmission-request data (101d) which are stored in the communication data table (101); and if the transmission states (101c) of all the other pieces of transmission-request data (101d) are not in a response waiting state, outputs the transmission-request data (101d) to the data transmitting means (14, 16), and changes, into a transmission completion state, the transmission state (101c) of the transmission-request data (101d) which is stored in the communication data table (101).

6. The communication apparatus according to claim 2,
wherein:
the data transmitting means (14, 16) has the function of transmitting the transmission data, after confirming there is not another piece of data on the communication path of the communication medium (17) before the transmission data is transmitted, and if there is not another piece of data on the communication path, confirming again there is not another piece of data on the communication path after a predetermined period of time elapses; and
the communication mediation processing means (12): if the transmission-request data (101d) is inputted, stores, in the communication data table (101), the data type information which is included in the transmission-request data (101d), and sets the transmission state (101c) to a transmission waiting state; if the data type information is the individual no-response-request data, confirms the transmission states (101c) of the other pieces of transmission-request data (101d) which are stored in the communication data table; and if the transmission states (101c) of all the other pieces of transmission-request data (101d) are not in a response waiting state, or if the transmission states (101c) of some of the other pieces of transmission-request data (101d) are in the response waiting state and all the transmission destinations of some of the other pieces of transmission-request data (101d) which are in the response waiting state are different from the transmission destination of the transmission-request data (101d), outputs the transmission-request data (101d) to the data transmitting means (14, 16), and changes, into a transmission completion state, the transmission state (101c) of the transmission-request data (101d) which is stored in the communication data table (101).

7. The communication apparatus according to claim 2,
wherein the communication mediation processing means (12):
if the transmission-request data (101d) is inputted, stores, in the communication data table (101), the data type information which is included in the transmission-request data (101d), and sets the transmission state (101c) to a transmission waiting state; if the data type information is the broadcast response-request data, confirms the transmission states (101c) of the other pieces of transmission-request data (101d) which are stored in the communication data table (101); and if the transmission states (101c) of all the other pieces of transmission-request data (101d) are not in a response waiting state, outputs the transmission-request data (101d) to the data transmitting means (14, 16), and changes, into the response waiting state, the transmission state (101c) of the transmission-request data (101d) which is stored in the communication data table (101).

8. The communication apparatus according to claim 2,
wherein:
the data transmitting means ((14, 16) has the function of transmitting the transmission data, after confirming there is not another piece of data on the communication path of the communication medium (17) before the transmission data is transmitted, and if there is not another piece of data on the communication path, confirming again there is not another piece of data on the communication path after a predetermined period of time elapses; and
the communication mediation processing means (12): if the transmission-request data (101d) is inputted, stores, in the communication data table (101), the data type information which is included in the transmission-request data (101d), and sets the transmission state (101c) to a transmission waiting state; if the data type information is the broadcast response-request data, confirms the transmission states (101c) of the other pieces of transmission-request data (101d) which are stored in the communication data table (101); and if the transmission states (101c) of all the other pieces of transmission-request data (101d) are not in a response waiting state, or if the transmission states (101c) of some of the other pieces of transmission-request data (101d) are in the response waiting state and all the types of some of the other pieces of transmission-request data (101d) which are in the response waiting state are broadcast, outputs the transmission-request data (101d) to the data transmitting means (14, 16), and changes, into the response waiting state, the transmission state (101c) of the transmission-request data (101d) which is stored in the communication data table (101) .

9. The communication apparatus according to claim 2,
wherein the communication mediation processing means (12):
if the transmission-request data (101d) is inputted, stores, in the communication data table (101), the data type information which is included in the transmission-request data (101d), and sets the transmission state (101c) to a transmission waiting state; if the data type information is the broadcast no-response-request data, confirms the transmission states (101c) of the other pieces of transmission-request data (101d) which are stored in the communication data table (101); and if the transmission states (101c) of all the other pieces of transmission-request data (101d) are not in a response waiting state, outputs the transmission-request data (101d) to the data transmitting means (14, 16), and changes, into a transmission completion state, the transmission state (101c) of the transmission-request data (101d) which is stored in the communication data table (101).

10. The communication apparatus according to claim 2,
wherein:
the data transmitting means (14, 16) has the function of transmitting the transmission data, after confirming there is not another piece of data on the communication path of the communication medium (17) before the transmission data is transmitted, and if there is not another piece of data on the communication path, confirming again there is not another piece of data on the communication path after a predetermined period of time elapses; and
the communication mediation processing means (12): if the transmission-request data (101d) is inputted, stores, in the communication data table (101), the data type information which is included in the transmission-request data (101d), and sets the transmission state (101c) to a transmission waiting state; if the data type information is the broadcast no-response-request data, confirms the transmission states (101c) of the other pieces of transmission-request data (101d) which are stored in the communication data table (101); and if the transmission states (101c) of all the other pieces of transmission-request data (101d) are not in a response waiting state, or if the transmission states (101c) of some of the other pieces of transmission-request data (101d) are in the response waiting state and all the types of some of the other pieces of transmission-request data (101d) which are in the response waiting state are broadcast, outputs the transmission-request data (101d) to the data transmitting means (14, 16), and changes, into a transmission completion state, the transmission state (101c) of the transmission-request data (101d) which is stored in the communication data table (101).

11. The communication apparatus according to claim 2,
wherein the communication mediation processing means (12):
if the transmission-request data (101d) is inputted, stores, in the communication data table (101), the data type information which is included in the transmission-request data (101d), and sets the transmission state (101c) to a transmission waiting state; if the data type information is the individual response-request data or the broadcast response-request data, after the transmission-request data (101d) is transmitted by the data transmitting means (14, 16), changes, into a response waiting state, the transmission state (101c) which corresponds to the transmission-request data (101d); and if no response is made even though a predetermined period of time elapses after the transmission state (101c) is changed into the response waiting state, changes the transmission state (101c) into a time-out state.

12. The communication apparatus according to claim 11,
wherein the communication mediation processing means (12) sets the predetermined period from the time when the transmission state (101c) is changed into the response waiting state to the time when the transmission state (101c) is shifted into the time-out state, according to the communication-medium type information which is stored in the communication-medium type-information storing means (161) .

13. The communication apparatus according to claim 11,
wherein the communication mediation processing means (12) sets the predetermined period from the time when the transmission state (101c) is changed into the response waiting state to the time when the transmission state (101c) is shifted into the time-out state, according to the data length of the transmission-request data (101d).

14. The communication apparatus according to claim 11,
wherein the communication mediation processing means (12) sets the predetermined period from the time when the transmission state (101c) is changed into the response waiting state to the time when the transmission state (101c) is shifted into the time-out state, according to the data length of response data to the transmission data.

15. The communication apparatus according to claim 1,
wherein:
the transmission-request data (101d) includes communication-medium specification information for specifying a communication medium to be used from among a plurality of the communication mediums (17a, 17b) which have a different standard from each other;
the communication mediation processing means (12) specifies a communication medium (17a, 17b) which transmits the transmission data, based on the communication-medium specification information that is included in the transmission-request data (101d); and
the data transmitting means (14, 16a, 16b) transmits the transmission data, using the communication medium (17a, 17b) which is specified by the communication mediation processing means (12).

16. A communication method in which data is transmitted to and received from another communication apparatus (11), via a communication medium (17), comprising:
a transmission-request data creating step of creating transmission request data (101d) which includes data type information that indicates a transmission destination of transmission data to be transmitted and whether or not a response should be made to the transmission data;
a communication-medium type-information storing step of storing communication-medium type information that indicates the type of the communication medium (17);
a transmission-request data storing step of storing the transmission-request data (101d) in a communication data table (101), wherein each piece of transmission-request data (101d) is stored so as to correspond to a transmission state (101c);
a communication mediation processing step (S201 - S211; S301 - S312; S401 - S411; S501 - S512; S601 - S611; S701 - S712; S801 - S811; S901 - S912) of determining the timing in transmitting the transmission data, based on the data type information which is included in the transmission request data (101d) that is created in the transmission-request data creating step, the communication-medium type information which is stored in the type-information storing step, and the transmission state of other pieces of transmission-request data stored in the communication data table (101); and
a data transmission processing step of transmitting the transmission data according to the timing which is determined in the communication mediation processing step.

17. A computer-readable record medium in which a communication program is recorded for transmitting and receiving data to and from another communication apparatus (11), via a communication medium (17), wherein the computer-readable record medium in which the communication program is recorded allows a computer to function as:
a transmission-request data creating means (15) for creating transmission request data (101d) which includes data type information that indicates a transmission destination of transmission data to be transmitted and whether or not a response should be made to the transmission data;
a communication-medium type-information storing means (161) for storing communication-medium type information that indicates the type of the communication medium (17);
a communication data table (101) for managing the transmission-request data (101d), wherein each piece of transmission-request data (101d) is stored so as to correspond to a transmission state (101c);
a communication mediation processing means (12) for determining the timing in transmitting the transmission data, based on the data type information which is included in the transmission request data (101d) that is created by the transmission-request data creating means (15), the communication-medium type information which is stored in the communication-medium type-information storing means (161), and the transmission state of other pieces of transmission-request data stored in the communication data table (101); and
a data transmitting means (14, 16) for transmitting the transmission data according to the timing which is determined by the communication mediation processing means (12).

## Patentansprüche

1. Kommunikationsvorrichtung (11), die Daten über ein Kommunikationsmedium (17) an eine andere Kommunikationsvorrichtung überträgt und von einer solchen empfängt, mit:
einer Übertragungsanforderungsdaten-Erzeugungseinrichtung (15) zum Erzeugen von Übertragungsanforderungsdaten (101d), die Datentypinformationen umfassen, welche ein Übertragungsziel von zu übertragenden Übertragungsdaten angeben und, ob eine Antwort auf die Übertragungsdaten erfolgen soll oder nicht;
einer Kommunikationsmedium-Typinformationen-Speichereinrichtung (161) zum Speichern von Kommunikationsmedium-Typinformationen, die den Typ des Kommunikationsmediums (17) angeben;
einer Kommunikationsdatentabelle (101) zum Verwalten der Übertragungsanforderungsdaten (101d), wobei jedes Stück von Übertragungsanforderungsdaten (101d) so gespeichert wird, dass es einem Übertragungszustand (101c) entspricht;
einer Kommunikationsmediationsverarbeitungseinrichtung (12) zum Bestimmen der Zeitsteuerung bei Übertragung der Übertragungsdaten basierend auf den Datentypinformationen, die in den Übertragungsanforderungsdaten (101d) enthalten sind, welche durch die Übertragungsanforderungsdaten-Erzeugungseinrichtung (15) erzeugt werden, den Kommunikationsmedium-Typinformationen, die in der Typinformationen-Speichereinrichtung (161) gespeichert werden, und dem Übertragungszustand von anderen Stücken von Übertragungsanforderungsdaten, die in der Kommunikationsdatentabelle (101) gespeichert werden; und
einer Datenübertragungseinrichtung (14, 16) zum Übertragen der Übertragungsdaten gemäß der Zeitsteuerung, die durch die Kommunikationsmediationsverarbeitungseinrichtung (12) bestimmt wird.

2. Kommunikationsvorrichtung gemäß Anspruch 1, wobei:
die Übertragungsanforderungsdaten (101d) Datentypinformationen umfassen, die angeben, dass die zu übertragenden Übertragungsdaten sind: Einzel-Antwort-Anforderungsdaten, die ein spezielles Übertragungsziel einzeln bezeichnen und eine Antwort von dem Übertragungsziel der Übertragungsdaten anfordern; EinzelohneAntwort-Anforderungsdaten, die ein spezielles Übertragungsziel einzeln bezeichnen und keine Antwort von dem Übertragungsziel der Übertragungsdaten anfordern; Rundsendung-Antwort-Anforderungsdaten, die die Übertragungsdatenrundsendung ohne Festlegung eines Übertragungsziels übertragen und eine Antwort von dem Übertragungsziel der Übertragungsdaten anfordern; oder Rundsendung-ohneAntwort-Anforderungsdaten, die die Übertragungsdatenrundsendung ohne Festlegung eines Übertragungsziels übertragen und keine Antwort von dem Übertragungsziel der Übertragungsdaten anfordern; und
die Kommunikationsmediationsverarbeitungseinrichtung (12) die Zeitsteuerung bei Übertragung der Übertragungsdaten basierend auf den Datentypinformationen, die in den Übertragungsanforderungsdaten (101d) enthalten sind, die durch die Übertragungsanforderungsdaten-Erzeugungseinrichtung (15) erzeugt werden, und den Kommunikationsmedium-Typinformationen, die in der Kommunikationsmedium-Typinformationen-Speichereinrichtung (161) gespeichert werden, bestimmt.

3. Kommunikationsvorrichtung gemäß Anspruch 2, wobei die Kommunikationsmediationsverarbeitungseinrichtung (12):
wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Einzel-Antwort-Anforderungsdaten sind, die Übertragungszustände (101c) von den anderen Stücken von Übertragungsanforderungsdaten (101d) bestätigt, die in der Kommunikationsdatentabelle (101) gespeichert werden; und wenn die Übertragungszustände (101c) von allen anderen Stücken von Übertragungsanforderungsdaten (101d) nicht in einem Antwortwartezustand sind, die Übertragungsanforderungsdaten (101d) an die Datenübertragungseinrichtung (14, 16) ausgibt und den Übertragungszustand (101c) der Übertragungsanforderungsdaten (101d), die in der Kommunikationsdatentabelle (101) gespeichert werden, in den Antwortwartezustand ändert.

4. Kommunikationsvorrichtung gemäß Anspruch 2, wobei:
die Datenübertragungseinrichtung (14, 16) die Funktion zum Übertragen der Übertragungsdaten aufweist, nachdem bestätigt ist, dass kein anderes Datenstück auf dem Kommunikationspfad des Kommunikationsmediums (17) ist, bevor die Übertragungsdaten übertragen werden, und, wenn kein anderes Datenstück auf dem Kommunikationspfad ist, erneut bestätigt ist, dass kein anderes Datenstück auf dem Kommunikationspfad ist, nachdem eine vorbestimmte Zeitdauer abgelaufen ist; und
die Kommunikationsmediationsverarbeitungseinrichtung (12): wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Einzel-Antwort-Anforderungsdaten sind, die Übertragungszustände (101c) der anderen Stücke von Übertragungsanforderungsdaten (101d) bestätigt, die in der Kommunikationsdatentabelle (101) gespeichert werden; und wenn die Übertragungszustände (101c) von allen anderen Stücken von Übertragungsanforderungsdaten (101d) nicht in einem Antwortwartezustand sind, oder wenn die Übertragungszustände (101c) von einigen der anderen Stücke von Übertragungsanforderungsdaten (101d) in dem Antwortwartezustand sind und alle Übertragungsziele von einigen der anderen Stücke von Übertragungsanforderungsdaten (101d), die in dem Antwortwartezustand sind, anders sind als das Übertragungsziel der Übertragungsanforderungsdaten (101d), die Übertragungsanforderungsdaten (101d) an die Datenübertragungseinrichtung (14, 16) ausgibt und den Übertragungszustand (101c) der Übertragungsanforderungsdaten (101d), die in der Kommunikationsdatentabelle (101) gespeichert werden, in den Antwortwartezustand ändert.

5. Kommunikationsvorrichtung gemäß Anspruch 2, wobei die Kommunikationsmediationsverarbeitungseinrichtung (12):
wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Einzel-ohneAntwort-Anforderungsdaten sind, die Übertragungszustände (101c) der anderen Stücke von Übertragungsanforderungsdaten (101d) bestätigt, die in der Kommunikationsdatentabelle (101) gespeichert werden; und wenn die Übertragungszustände (101c) von allen anderen Stücken von Übertragungsanforderungsdaten (101d) nicht in einem Antwortwartezustand sind, die Übertragungsanforderungsdaten (101d) an die Datenübertragungseinrichtung (14, 16) ausgibt und den Übertragungszustand (101c) der Übertragungsanforderungsdaten (101d), die in der Kommunikationsdatentabelle (101) gespeichert werden, in einen Übertragungsvollendungszustand ändert.

6. Kommunikationsvorrichtung gemäß Anspruch 2, wobei:
die Datenübertragungseinrichtung (14, 16) die Funktion zum Übertragen der Übertragungsdaten aufweist, nachdem bestätigt ist, dass kein anderes Datenstück auf dem Kommunikationspfad des Kommunikationsmediums (17) ist, bevor die Übertragungsdaten übertragen werden, und, wenn kein anderes Datenstück auf dem Kommunikationspfad ist, erneut bestätigt ist, dass kein anderes Datenstück auf dem Kommunikationspfad ist, nachdem eine vorbestimmte Zeitdauer abgelaufen ist; und
die Kommunikationsmediationsverarbeitungseinrichtung (12): wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Einzel-ohneAntwort-Anforderungsdaten sind, die Übertragungszustände (101c) der anderen Stücke von Übertragungsanforderungsdaten (101d) bestätigt, die in der Kommunikationsdatentabelle gespeichert werden; und wenn die Übertragungszustände (101c) von allen anderen Stücken von Übertragungsanforderungsdaten (101d) nicht in einem Antwortwartezustand sind, oder wenn die Übertragungszustände (101c) von einigen der anderen Stücke von Übertragungsanforderungsdaten (101d) in dem Antwortwartezustand sind und alle Übertragungsziele von einigen der anderen Stücke von Übertragungsanforderungsdaten (101d), die in dem Antwortwartezustand sind, anders sind als das Übertragungsziel der Übertragungsanforderungsdaten (101d), die Übertragungsanforderungsdaten (101d) an die Datenübertragungseinrichtung (14, 16) ausgibt und den Übertragungszustand (101c) der Übertragungsanforderungsdaten (101d), die in der Kommunikationsdatentabelle (101) gespeichert werden, in einen Übertragungsvollendungszustand ändert.

7. Kommunikationsvorrichtung gemäß Anspruch 2, wobei die Kommunikationsmediationsverarbeitungseinrichtung (12):
wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Rundsendung-Antwort-Anforderungsdaten sind, die Übertragungszustände (101c) der anderen Stücke von Übertragungsanforderungsdaten (101d) bestätigt, die in der Kommunikationsdatentabelle (101) gespeichert werden; und wenn die Übertragungszustände (101c) von allen anderen Stücken von Übertragungsanforderungsdaten (101d) nicht in einem Antwortwartezustand sind, die Übertragungsanforderungsdaten (101d) an die Datenübertragungseinrichtung (14, 16) ausgibt und den Übertragungszustand (101c) der Übertragungsanforderungsdaten (101d) die in der Kommunikationsdatentabelle (101) gespeichert werden, in den Antwortwartezustand ändert.

8. Kommunikationsvorrichtung gemäß Anspruch 2, wobei:
die Datenübertragungseinrichtung (14, 16) die Funktion zum Übertragen der Übertragungsdaten aufweist, nachdem bestätigt ist, dass kein anderes Datenstück auf dem Kommunikationspfad des Kommunikationsmediums (17) ist, bevor die Übertragungsdaten übertragen werden, und, wenn kein anderes Datenstück auf dem Kommunikationspfad ist, erneut bestätigt ist, dass kein anderes Datenstück auf dem Kommunikationspfad ist, nachdem eine vorbestimmte Zeitdauer abgelaufen ist; und
die Kommunikationsmediationsverarbeitungseinrichtung (12): wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Rundsendung-Antwort-Anforderungsdaten sind, die Übertragungszustände (101c) der anderen Stücke von Übertragungsanforderungsdaten (101d) bestätigt, die in der Kommunikationsdatentabelle (101) gespeichert werden; und wenn die Übertragungszustände (101c) von allen anderen Stücken von Übertragungsanforderungsdaten (101d) nicht in einem Antwortwartezustand sind, oder wenn die Übertragungszustände (101c) von einigen der anderen Stücke von Übertragungsanforderungsdaten (101d) in dem Antwortwartezustand sind und alle Typen von einigen der anderen Stücke von Übertragungsanforderungsdaten (101d), die in dem Antwortwartezustand sind, Rundsendung sind, die Übertragungsanforderungsdaten (101d) an die Datenübertragungseinrichtung (14, 16) ausgibt und den Übertragungszustand (101c) der Übertragungsanforderungsdaten (101d), die in der Kommunikationsdatentabelle (101) gespeichert werden, in den Antwortwartezustand ändert.

9. Kommunikationsvorrichtung gemäß Anspruch 2, wobei die Kommunikationsmediationsverarbeitungseinrichtung (12):
wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Rundsendung-ohneAntwort-Anforderungsdaten sind, die Übertragungszustände (101c) der anderen Stücke von Übertragungsanforderungsdaten (101d) bestätigt, die in der Kommunikationsdatentabelle (101) gespeichert werden; und wenn die Übertragungszustände (101c) von allen anderen Stücken von Übertragungsanforderungsdaten (101d) nicht in einem Antwortwartezustand sind, die Übertragungsanforderungsdaten (101d) an die Datenübertragungseinrichtung (14, 16) ausgibt und den Übertragungszustand (101c) der Übertragungsanforderungsdaten (101d), die in der Kommunikationsdatentabelle (101) gespeichert werden, in einen Übertragungsvollendungszustand ändert.

10. Kommunikationsvorrichtung gemäß Anspruch 2, wobei:
die Datenübertragungseinrichtung (14, 16) die Funktion zum Übertragen der Übertragungsdaten aufweist, nachdem bestätigt ist, dass kein anderes Datenstück auf dem Kommunikationspfad des Kommunikationsmediums (17) ist, bevor die Übertragungsdaten übertragen werden, und, wenn kein anderes Datenstück auf dem Kommunikationspfad ist, erneut bestätigt ist, dass kein anderes Datenstück auf dem Kommunikationspfad ist, nachdem eine vorbestimmte Zeitdauer abgelaufen ist; und
die Kommunikationsmediationsverarbeitungseinrichtung (12): wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Rundsendung-ohneAntwort-Anforderungsdaten sind, die Übertragungszustände (101c) der anderen Stücke von Übertragungsanforderungsdaten (101d) bestätigt, die in der Kommunikationsdatentabelle (101) gespeichert werden; und wenn die Übertragungszustände (101c) von allen anderen Stücken von Übertragungsanforderungsdaten (101d) nicht in einem Antwortwartezustand sind, oder wenn die Übertragungszustände (101c) von einigen der anderen Stücke von Übertragungsanforderungsdaten (101d) in dem Antwortwartezustand sind und alle Typen von einigen der anderen Stücke von Übertragungsanforderungsdaten (101d), die in dem Antwortwartezustand sind, Rundsendung sind, die Übertragungsanforderungsdaten (101d) an die Datenübertragungseinrichtung (14, 16) ausgibt und den Übertragungszustand (101c) der Übertragungsanforderungsdaten (101d), die in der Kommunikationsdatentabelle (101) gespeichert werden, in einen Übertragungsvollendungszustand ändert.

11. Kommunikationsvorrichtung gemäß Anspruch 2, wobei die Kommunikationsmediationsverarbeitungseinrichtung (12):
wenn die Übertragungsanforderungsdaten (101d) eingegeben werden, die Datentypinformationen, die in den Übertragungsanforderungsdaten (101d) enthalten sind, in der Kommunikationsdatentabelle (101) speichert und den Übertragungszustand (101c) in einen Übertragungswartezustand setzt; wenn die Datentypinformationen die Einzel-Antwort-Anforderungsdaten oder die Rundsendung-Antwort-Anforderungsdaten sind, nachdem die Übertragungsanforderungsdaten (101d) durch die Datenübertragungseinrichtung (14, 16) übertragen sind, den Übertragungszustand (101c), der den Übertragungsanforderungsdaten (101d) entspricht, in einen Antwortwartezustand ändert; und wenn keine Antwort erfolgt, obwohl eine vorbestimmte Zeitdauer abgelaufen ist, nachdem der Übertragungswartezustand (101c) in den Antwortwartezustand geändert ist, den Übertragungszustand (101c) in einen Zeitüberschreitungszustand ändert.

12. Kommunikationsvorrichtung gemäß Anspruch 11, wobei die Kommunikationsmediationsverarbeitungseinrichtung (12) die vorbestimmte Dauer gemäß den Kommunikationsmedium-Typinformationen, die in der Kommunikationsmedium-Typinformationen-Speichereinrichtung (161) gespeichert werden, von der Zeit, zu der der Übertragungszustand (101c) in den Antwortwartezustand geändert wird, bis zu der Zeit einstellt, zu der der Übertragungszustand (101c) in den Zeiüberschreitungszustand verlagert wird.

13. Kommunikationsvorrichtung gemäß Anspruch 11, wobei die Kommunikationsmediationsverarbeitungseinrichtung (12) die vorbestimmte Dauer gemäß der Datenlänge der Übertragungsanforderungsdaten (101d) von der Zeit, zu der der Übertragungszustand (101c) in den Antwortwartezustand geändert wird, bis zu der Zeit einstellt, zu der der Übertragungszustand (101c) in den Zeitüberschreitungszustand verlagert wird.

14. Kommunikationsvorrichtung gemäß Anspruch 11, wobei die Kommunikationsmediationsverarbeitungseinrichtung (12) die vorbestimmte Dauer gemäß der Datenlänge von Antwortdaten auf die Übertragungsdaten von der Zeit, zu der der Übertragungszustand (101c) in den Antwortwartezustand geändert wird, bis zu der Zeit einstellt, zu der der Übertragungszustand (101c) in den Zeitüberschreitungszustand verlagert wird.

15. Kommunikationsvorrichtung gemäß Anspruch 1, wobei:
die Übertragungsanforderungsdaten (101d) Kommunikationsmedium-Festlegungsinformationen zum Festlegen eines zu verwendenden Kommunikationsmediums aus einer Vielzahl der Kommunikationsmedien (17a, 17b) umfasst, die einen voneinander unterschiedlichen Standart aufweisen;
die Kommunikationsmediationsverarbeitungseinrichtung (12) ein Kommunikationsmedium (17a, 17b), das die Übertragungsdaten überträgt, basierend auf den Kommunikationsmedium-Festlegungsinformationen festlegt, die in den Übertragungsanforderungsdaten (101d) enthalten sind; und
die Datenübertragungseinrichtung (14, 16a, 16b) die Übertragungsdaten unter Verwendung des Kommunikationsmediums (17a, 17b) überträgt, das durch die Kommunikationsmediationsverarbeitungseinrichtung (12) festgelegt wird.

16. Kommunikationsverfahren, bei dem Daten über ein Kommunikationsmedium (17) an eine andere Kommunikationsvorrichtung (11) übertragen und von einer solchen empfangen werden, mit:
einem Übertragungsanforderungsdaten-Erzeugungsschritt zum Erzeugen von Übertragungsanforderungsdaten (101d), die Datentypinformationen umfassen, welche ein Übertragungsziel von zu übertragenden Übertragungsdaten angeben und, ob eine Antwort auf die Übertragungsdaten erfolgen soll oder nicht;
einem Kommunikationsmedium-Typinformationen-Speicherschritt zum Speichern von Kommunikationsmedium-Typinformationen, die den Typ des Kommunikationsmediums (17) angeben;
einem Übertragungsanforderungsdaten-Speicherschritt zum Speichern der Übertragungsanforderungsdaten (101d) in einer Kommunikationsdatentabelle (101), wobei jedes Stück von Übertragungsanforderungsdaten (101d) so gespeichert wird, dass es einem Übertragungszustand (101c) entspricht;
einem Kommunikationsmediationsverarbeitungsschritt (S201 bis S211; S301 bis S312; S401 bis S411; S501 bis S512; S601 bis S611; S701 bis S712; S801 bis S811; S901 bis S912) zum Bestimmen der Zeitsteuerung bei Übertragung der Übertragungsdaten basierend auf den Datentypinformationen, die in den Übertragungsanforderungsdaten (101d) enthalten sind, welche in dem Übertragungsanforderungsdaten-Erzeugungsschritt erzeugt werden, den Kommunikationsmedium-Typinformationen, die in dem Typinformationen-Speicherschritt gespeichert werden, und dem Übertragungszustand von anderen Stücken von Übertragungsanforderungsdaten, die in der Kommunikationsdatentabelle (101) gespeichert werden; und
einem Datenübertragungsverarbeitungsschritt zum Übertragen der Übertragungsdaten gemäß der Zeitsteuerung, die in dem Kommunikationsmediationsverarbeitungsschritt bestimmt wird.

17. Computer-lesbares Aufzeichnungsmedium, in dem ein Kommunikationsprogramm zum Übertragen von Daten an und Empfangen von Daten von einer anderen Kommunikationsvorrichtung (11) über ein Kommunikationsmedium (17) aufgezeichnet ist, wobei das Computer-lesbare Aufzeichnungsmedium, in dem das Kommunikationsprogramm aufgezeichnet ist, einem Computer ermöglicht, dass dieser arbeitet als:
eine Übertragungsanforderungsdaten-Erzeugungseinrichtung (15) zum Erzeugen von Übertragungsanforderungsdaten (101d), die Datentypinformationen umfassen, welche ein Übertragungsziel von zu übertragenden Übertragungsdaten angeben und, ob eine Antwort auf die Übertragungsdaten erfolgen soll oder nicht;
eine Kommunikationsmedium-Typinformationen-Speichereinrichtung (161) zum Speichern von Kommunikationsmedium-Typinformationen, die den Typ des Kommunikationsmediums (17) angeben;
eine Kommunikationsdatentabelle (101) zum Verwalten der Übertragungsanforderungsdaten (101d), wobei jedes Stück von Übertragungsanforderungsdaten (101d) so gespeichert wird, dass es einem Übertragungszustand (101c) entspricht;
eine Kommunikationsmediationsverarbeitungseinrichtung (12) zum Bestimmen der Zeitsteuerung bei Übertragung der Übertragungsdaten basierend auf den Datentypinformationen, die in den Übertragungsanforderungsdaten (101d) enthalten sind, welche durch die Übertragungsanforderungsdaten-Erzeugungseinrichtung (15) erzeugt werden, den Kommunikationsmedium-Typinformationen, die in der Kommunikationsmedium-Typinformationen-Speichereinrichtung (161) gespeichert werden, und dem Übertragungszustand von anderen Stücken von Übertragungsanforderungsdaten, die in der Kommunikationsdatentabelle (101) gespeichert werden; und
eine Datenübertragungseinrichtung (14, 16) zum Übertragen der Übertragungsdaten gemäß der Zeitsteuerung, die durch die Kommunikationsmediationsverarbeitungseinrichtung (12) bestimmt wird.

## Revendications

1. Appareil de communication (11) qui émet et reçoit des données à destination et en provenance d'un autre appareil de communication, via un moyen de communication (17), comportant :
un moyen de création de données de demande d'émission (15) servant à créer des données de demande d'émission (101d) qui comportent des informations relatives au type de données qui indiquent une destination d'émission pour les données d'émission devant être émises et si, oui ou non, il convient qu'une réponse soit apportée aux données d'émission ;
un moyen de stockage d'informations relatives au type du moyen de communication (161) servant à stocker des informations relatives au type de moyen de communication qui indiquent le type du moyen de communication (17) ;
une table de données de communication (101) pour gérer les données de demande d'émission (101d), dans lequel chaque élément des données de demande d'émission (101d) est stocké de sorte à correspondre à un état d'émission (101c) ;
un moyen de traitement à médiation de communication (12) servant à déterminer la synchronisation pour émettre des données d'émission, en se basant sur les informations relatives au type de données qui sont incluses dans les données de demande d'émission (101d) qui sont créées par le moyen de création de données de demande d'émission (15), sur les informations relatives au type du moyen de communication qui sont stockées dans le moyen de stockage d'informations de type (161), et sur l'état d'émission d'autres éléments de données de demande d'emission stockés dans la table de données de communication (101) ; et
un moyen d'émission de données (14, 16) servant à émettre les données d'émission en fonction de la synchronisation qui est déterminée par le moyen de traitement à médiation de communication (12).

2. Appareil de communication selon la revendication 1, dans lequel :
les données de demande d'émission (101d) comportent les informations relatives au type des données qui indiquent que les données d'émission devant être émises sont : des données individuelles de demande de réponse qui désignent individuellement une destination d'émission spécifique et demandent une réponse de la part de la destination d'émission des données d'émission ; des données individuelles de non-demande de réponse qui désignent individuellement une destination d'émission spécifique et ne demandent pas une réponse de la part de la destination d'émission des données d'émission ;
des données de demande de réponse de diffusion qui émettent les données d'émission diffusées sans spécifier de destination d'émission et demandent une réponse de la part de la destination d'émission des données d'émission ; ou
des données de non-demande de réponse de diffusion qui émettent les données d'émission diffusées sans spécifier de destination d'émission et ne demandent pas de réponse de la part de la destination d'émission des données d'émission ; et
le moyen de traitement à médiation de communication (12) détermine la synchronisation pour émettre les données d'émission, en se basant sur les informations relatives au type des données qui sont incluses dans les données de demande d'émission (101d) qui sont créées par le moyen de création de données de demande d'émission (15) et sur les informations relatives au type du moyen de communication qui sont stockées dans le moyen de stockage d'informations relatives au type de moyen de communication (161).

3. Appareil de communication selon la revendication 2, dans lequel le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données individuelles de demande de réponse, confirme les états d'émission (101c) des autres éléments des données de demande d'émission (101d) qui sont stockés dans la table de données de communication (101) ; et si les états d'émission (101c) de tous les autres éléments de données de demande d'émission (101d) ne sont pas dans un état d'attente de réponse, injecte les données de demande d'émission (101d) dans le moyen d'émission de données (14, 16), et fait passer à l'état d'attente de réponse l'état d'émission (101c) des données de demande d'émission (101d) qui sont stockées dans la table de données de communication (101).

4. Appareil de communication selon la revendication 2, dans lequel :
le moyen d'émission de données (14, 16) a la fonction d'émettre les données d'émission, après avoir confirmé qu'il n'y a aucun autre élément de donnée sur la voie de communication du moyen de communication (17) avant que les données d'émission ne soient émises, et s'il n'y a aucun autre élément de donnée sur la voie de communication, confirmer à nouveau qu'il n'y a aucun autre élément de donnée sur la voie de communication au bout d'une durée prédéterminée ; et
le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données individuelles de demande de réponse, confirme les états d'émission (101c) des autres éléments de données de demande d'émission (101d) qui sont stockés dans la table de données de communication (101) ; et si les états d'émission (101c) de tous les autres éléments de données de demande d'émission (101d) ne sont pas dans un état d'attente de réponse, ou si les états d'émission (101c) d'un certain nombre des autres éléments de données de demande d'émission (101d) sont dans l'état d'attente de réponse et toutes les destinations d'émission d'un certain nombre des autres éléments de données de demande d'émission 101d) qui sont dans l'état d'attente de réponse sont différentes de la destination d'émission pour les données de demande d'émission (101d), injecte les données de demande d'émission (101d) dans le moyen d'émission de données (14, 16), et fait passer à l'état d'attente de réponse l'état d'émission (101c) des données de demande d'émission (101d) qui sont stockées dans la table de données de communication (101).

5. Appareil de communication selon la revendication 2, dans lequel le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données individuelles de non-demande de réponse, confirme les états d'émission (101c) des autres éléments de données de demande d'émission (101d) qui sont stockées dans la table de données de communication (101) ; et si les états d'émission (101c) de tous les autres éléments de données de demande d'émission (101d) ne sont pas dans un état d'attente de réponse, injecte les données de demande d'émission (101d) dans le moyen d'émission de données (14, 16), et fait passer à un état d'achèvement d'émission l'état d'émission (101c) des données de demande d'émission (101d) qui sont stockées dans la table de données de communication (101).

6. Appareil de communication selon la revendication 2, dans lequel :
le moyen d'émission de données (14, 16) a la fonction d'émettre les données d'émission, après avoir confirmé qu'il n'y a aucun autre élément de donnée sur la voie de communication du moyen de communication (17) avant que les données d'émission ne soient émises, et s'il n'y a aucun autre élément de donnée sur la voie de communication, de confirmer à nouveau qu'il n'y a aucun autre élément de donnée sur la voie de communication au bout d'une durée prédéterminée ; et
le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données individuelles de non-demande de réponse, confirme les états d'émission (101c) des autres éléments de données de demande d'émission (101d) qui sont stockés dans la table de données de communication ; et si les états d'émission (101c) de tous les autres éléments de données de demande d'émission (101d) ne sont pas dans un état d'attente de réponse, ou si les états d'émission (101c) d'un certain nombre des autres éléments de données de demande d'émission (101d) sont dans l'état d'attente de réponse et toutes les destinations d'émission d'un certain nombre des autres éléments des données de demande d'émission (101d) qui sont dans l'état d'attente de réponse sont différentes de la destination d'émission pour les données de demande d'émission (101d), injecte les données de demande d'émission (101d) dans le moyen d'émission de données (14, 16), et fait passer à un état d'achèvement d'émission l'état d'émission (101c) des données de demande d'émission (101d) qui sont stockées dans la table de données de communication (101).

7. Appareil de communication selon la revendication 2, dans lequel le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données de demande de réponse de diffusion, confirme les états d'émission (101c) des autres éléments de données de demande d'émission (101d) qui sont stockés dans la table de données de communication (101) ; et si les états d'émission (101c) de tous les autres éléments de données de demande d'émission (101d) ne sont pas dans un état d'attente de réponse, injecte les données de demande d'émission (101d) dans le moyen d'émission de données (14, 16), et fait passer à l'état d'attente de réponse l'état d'émission (101c) des données de demande d'émission (101d) qui sont stockées dans la table de données de communication (101) .

8. Appareil de communication selon la revendication 2, dans lequel :
le moyen d'émission de données (14, 16) a la fonction d'émettre les données d'émission, après avoir confirmé qu'il n'y a aucun autre élément de donnée sur la voie de communication du moyen de communication (17) avant que les données d'émission ne soient émises, et s'il n'y a aucun autre élément de donnée sur la voie de communication, de confirmer à nouveau qu'il n'y a aucun autre élément de donnée sur la voie de communication au bout d'une durée prédéterminée ; et
le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données de demande de réponse de diffusion, confirme les états d'émission (101c) des autres éléments de données de demande d'émission (101d) qui sont stockés dans la table de données de communication (101) ; et si les états d'émission (101c) de tous les autres éléments de données de demande d'émission (101d) ne sont pas dans un état d'attente de réponse, ou si les états d'émission (101c) d'un certain nombre des autres éléments de données de demande d'émission (101d) sont dans l'état d'attente de réponse et tous les types d'un certain nombre des autres éléments de données de demande d'émission (101d) qui sont dans l'état d'attente de réaction sont diffusés, injecte les données de demande d'émission (101d) dans le moyen d'émission de données (14, 16), et fait passer à l'état d'attente de réponse l'état d'émission (101c) des données de demande d'émission (101d) qui sont stockées dans la table de données de communication (101).

9. Appareil de communication selon la revendication 2, dans lequel le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données de non-demande de réponse de diffusion, confirme les états d'émission (101c) des autres éléments de données de demande d'émission (101d) qui sont stockés dans la table de données de communication (101) ; et si les états d'émission (101c) de tous les autres éléments de données de demande d'émission (101d) ne sont pas dans un état d'attente de réponse, injecte les données de demande d'émission (101d) dans le moyen d'émission de données (14, 16), et fait passer à un état d'achèvement d'émission l'état d'émission (101c) des données de demande d'émission (101d) qui sont stockées dans la table de données de communication (101) .

10. Appareil de communication selon la revendication 2, dans lequel :
le moyen d'émission de données (14, 16) a la fonction d'émettre les données d'émission, après avoir confirmé qu'il n'y a aucun autre élément de donnée sur la voie de communication du moyen de communication (17) avant que les données d'émission ne soient émises, et s'il n'y a aucun autre élément de donnée sur la voie de communication, de confirmer à nouveau qu'il n'y a aucun autre élément de donnée sur la voie de communication au bout d'une durée prédéterminée ; et
le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données de non-demande de réponse de diffusion, confirme les états d'émission (101c) des autres éléments de données de demande d'émission (101d) qui sont stockés dans la table de données de communication (101) ; et si les états d'émission (101c) de tous les autres éléments de données de demande d'émission (101d) ne sont pas dans un état d'attente de réponse, ou si les états d'émission (101c) d'un certain nombre des autres éléments de données de demande d'émission (101d) sont dans l'état d'attente de réponse et tous les types d'un certain nombre des autres éléments de données de demande d'émission (101d) qui sont dans l'état d'attente de réponse sont diffusés, injecte les données de demande d'émission (101d) dans le moyen d'émission de données (14, 16), et fait passer à un état d'achèvement d'émission l'état d'émission (101c) des données de demande d'émission (101d) qui sont stockées dans la table de données de communication (101).

11. Appareil de communication selon la revendication 2, dans lequel le moyen de traitement à médiation de communication (12) : si les données de demande d'émission (101d) sont injectées en entrée, stocke dans la table de données de communication (101) les informations relatives au type des données qui sont incluses dans les données de demande d'émission (101d), et met l'état d'émission (101c) sur un état d'attente d'émission ; si les informations relatives au type des données sont les données individuelles de demande de réponse ou les données de demande de réponse de diffusion, après que les données de demande d'émission (101d) ont été émises par le moyen d'émission de données (14, 16), fait passer à un état d'attente de réponse l'état d'émission (101c) qui correspond aux données de demande d'émission (101d) ; et si aucune réponse n'est faite malgré qu'une durée prédéterminée se soit écoulée après que l'état d'émission (101c) a été modifié en état d'attente de réponse, fait passer l'état d'émission (101c) à un état de temporisation.

12. Appareil de communication selon la revendication 11, dans lequel le moyen de traitement à médiation de communication (12) règle la durée prédéterminée allant de l'instant où l'état d'émission (101c) a été modifié en état d'attente de réponse jusqu'à l'instant où l'état d'émission (101c) est passé à l'état de temporisation, en fonction des informations relatives au type du moyen de communication qui sont stockées dans le moyen de stockage des informations relatives au type de moyen de communication (161).

13. Appareil de communication selon la revendication 11, dans lequel le moyen de traitement à médiation de communication (12) règle la durée prédéterminée allant de l'instant où l'état d'émission (101c) a été modifié en état d'attente de réponse jusqu'à l'instant où l'état d'émission (101c) est passé à l'état de temporisation, en fonction de la longueur de données des données de demande d'émission (101d).

14. Appareil de communication selon la revendication 11, dans lequel le moyen de traitement à médiation de communication (12) règle la durée prédéterminée allant de l'instant où l'état d'émission (101c) a été modifié en état d'attente de réponse jusqu'à l'instant où l'état d'émission (101c) est passé à l'état de temporisation, en fonction de la longueur de données des données de réponse aux données d'émission.

15. Appareil de communication selon la revendication 1, dans lequel :
les données de demande d'émission (101d) comportent des informations de spécification du moyen de communication pour spécifier un moyen de communication à utiliser parmi une pluralité de moyens de communication (17a, 17b) qui ont une norme différente entre eux ;
le moyen de traitement à médiation de communication (12) spécifie un moyen de communication (17a, 17b) qui émet les données d'émission, en se basant sur les informations de spécification du moyen de communication qui sont incluses dans les données de demande d'émission (101d) ; et
le moyen d'émission de données (14, 16a, 16b) émet les données d'émission, en utilisant le moyen de communication (17a, 17b) qui est spécifié par le moyen de traitement à médiation de communication (12).

16. Procédé de communication dans lequel des données sont émises et reçues à destination et en provenance d'un autre appareil de communication (11), via un moyen de communication (17), comportant :
une étape de création de données de demande d'émission consistant à créer des données de demande d'émission (101d) qui comprennent des informations relatives au type des données qui indiquent une destination d'émission des données d'émission devant être émises et si, oui ou non, il convient qu'une réponse soit apportée aux données d'émission ;
une étape de stockage d'informations relatives au type du moyen de communication consistant à stocker des informations relatives au type de moyen de communication qui indiquent le type du moyen de communication (17) ;
une étape de stockage de données de demande d'émission consistant à stocker les données de demande d'émission (101d) dans une table de données de communication (101), dans lequel chaque élément des données de demande d'émission (101d) est stocké de sorte à correspondre à un état d'émission (101c) ;
une étape de traitement à médiation de communication (S201 à S211 ; S301 à S312 ; S401 à S411 ; S501 à S512 ; S601 à S611 ; S701 à S712 ; S801 à S811 ; S901 à S912) consistant à déterminer la synchronisation pour émettre les données d'émission, en se basant sur les informations relatives au type des données qui sont incluses dans les données de demande d'émission (101d) qui sont créées dans l'étape de création de données de demande d'émission, sur les informations relatives au type du moyen de communication qui sont stockées dans l'étape de stockage des informations de type, et sur l'état d'autres éléments des données de demande d'emission stockés dans la table de données de communication (101) ; et
une étape de traitement d'émission de données consistant à émettre les données d'émission en fonction de la synchronisation qui a été déterminée dans l'étape de traitement à médiation de communication.

17. Support d'enregistrement lisible par ordinateur dans lequel un logiciel de communication est enregistré pour émettre et recevoir des données en direction et en provenance d'un autre appareil de communication (11), via un moyen de communication (17), dans lequel le support d'enregistrement lisible par ordinateur dans lequel est enregistré le logiciel de communication permet à l'ordinateur de fonctionner comme :
un moyen de création de données de demande d'émission (15) servant à créer des données de demande d'émission (101d) qui comportent des informations relatives au type des données qui indiquent une destination d'émission pour les données d'émission devant être émises et si, oui ou non, il convient qu'une réponse soit apportée aux données d'émission ;
un moyen de stockage d'informations relatives au type du moyen de communication (161) pour stocker des informations relatives au type de moyen de communication qui indiquent le type du moyen de communication (17) ;
une table de données de communication (101) pour gérer les données de demande d'émission (101d), dans lequel chaque élément des données de demande d'émission (101d) est stocké de sorte à correspondre à un état d'émission (101c) ;
un moyen de traitement à médiation de communication (12) servant à déterminer la synchronisation pour émettre les données d'émission, en se basant sur les informations relatives au type de données qui sont incluses dans les données de demande d'émission (101d) qui sont créées par le moyen de création de données de demande d'émission (15), sur les informations relatives au type du moyen de communication qui sont stockées dans le moyen de stockage d'informations relatives au type de moyen de communication (161), et sur l'état d'émission d'autres éléments de données de demande d'emission stockés dans la table de données de communication (101) ; et
un moyen d'émission de données (14, 16) servant à émettre les données d'émission en fonction de la synchronisation qui a été déterminée par le moyen de traitement à médiation de communication (12).
